(19) Europäisches Patentamt
European Patent Office
Office européen des brevets

(11) **EP 4 435 516 A1**

(12) **EUROPEAN PATENT APPLICATION**

(43) Date of publication:
**25.09.2024 Bulletin 2024/39**

(21) Application number: **24161393.4**

(22) Date of filing: **05.03.2024**

(51) International Patent Classification (IPC):
***G03F 7/075*** *(2006.01)* ***G03F 7/09*** *(2006.01)*
***G03F 7/11*** *(2006.01)*

(52) Cooperative Patent Classification (CPC):
**G03F 7/094; G03F 7/0752; G03F 7/11**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **16.03.2023 JP 2023042351**
**01.12.2023 JP 2023203995**

(71) Applicant: **SHIN-ETSU CHEMICAL CO., LTD.**
**Tokyo 1000005 (JP)**

(72) Inventors:
- **KOBAYASHI, Naoki**
  **Niigata (JP)**
- **NAGAMACHI, Nobuhiro**
  **Niigata, Niigata (JP)**
- **ISHIWATA, Kenta**
  **Niigata (JP)**
- **KORI, Daisuke**
  **Niigata (JP)**

(74) Representative: **Sonnenhauser, Thomas Martin**
**Wuesthoff & Wuesthoff**
**Patentanwälte und Rechtsanwalt PartG mbB**
**Schweigerstraße 2**
**81541 München (DE)**

(54) **METHOD FOR FORMING RESIST UNDERLAYER FILM AND PATTERNING PROCESS**

(57) The present invention is a method for forming a resist underlayer film, including the steps of: (i) coating a substrate with a composition for forming a resist underlayer film containing a metal compound having a metal-oxygen covalent bond and an organic solvent; (ii) forming a cured film by heating the coated substrate at a temperature of 100°C or higher and 600°C or lower for 10 seconds to 7,200 seconds for curing; and (iii) forming a resist underlayer film by irradiating the cured film with plasma, where a compound containing at least one crosslinking group represented by the following general formulae (a-1) to (a-4), (b-1) to (b-4), and (c-1) to (c-3) is used as the metal compound. This provides: a method for forming a resist underlayer film that contains metal and that exhibits both high filling property and high dry etching resistance; and a patterning process using the method.

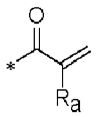
(a-1)

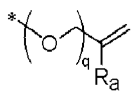
(a-2)

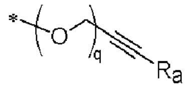
(a-3)

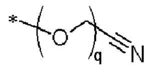
(a-4)

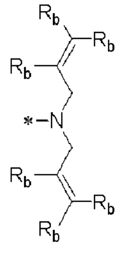
(b-1)

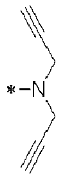
(b-2)

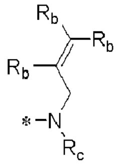
(b-3)

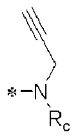
(b-4)

EP 4 435 516 A1

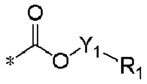

(c-1)

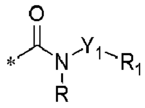

(c-2)

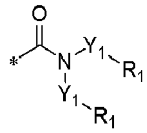

(c-3)

## Description

TECHNICAL FIELD

The present invention relates to: a method for forming a resist underlayer film; and a patterning process.

BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry-etched with a thinner photoresist film having lower etching resistance. Therefore, a demand for finding a composition used in this processing and the process therefor has become urgent.

A multilayer resist method is one of the solutions for the above problems. This method is as follows: a resist underlayer film having a different etching selectivity from a photoresist film (i.e., a resist upper layer film) is placed between the resist upper layer film and a substrate to be processed; a pattern is formed in the resist upper layer film; the pattern is transferred to the resist underlayer film by dry etching while using the resist upper layer film pattern as a dry etching mask; and the pattern is further transferred to the substrate to be processed by dry etching while using the resist underlayer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1, for example.

On the other hand, in recent years, with the rapid miniaturization of DRAM memory, there is a growing need for further improvement in dry etching resistance, as well as a need for a resist underlayer film having excellent filling and planarizing properties. As a coating-type resist underlayer film composition excellent in filling and planarizing properties, for example, the composition disclosed in Patent Document 2 has been reported. In addition, it has been reported

in Patent Document 3 that the dry etching resistance of a resist underlayer film composition can be improved by plasma irradiation, electron beam irradiation, and/or ion irradiation. However, in view of application of this composition in the advanced generation, there is a concern about the dry etching resistance of resist underlayer film compositions. The application limit of the previously-known coating-type resist underlayer film composition is thus approaching.

To solve the problems, there is consideration of development of the use of a material containing a metal element for a resist underlayer film. Patent Document 4 reports that a material containing a Ti compound exhibits excellent dry etching resistance to $CHF_3/CF_4$-based gas and $CO_2/N_2$-based gas.

On the other hand, filling property is a problem when using a metal compound for a resist underlayer film. Although there is no mention of filling property in Patent Document 4, a metal compound generally undergoes great thermal shrinkage during baking and induces remarkable degradation of filling after baking at a high temperature. Therefore, there is a concern that such a compound is insufficient as a resist underlayer film material for which high planarizing and filling properties and heat resistance are required.

Patent Documents 5 and 6 report that a metal compound modified with a particular ligand has excellent filling property. However, the baking temperature in the performed filling property evaluation is a low temperature of 150°C, and there is a concern that the compound is insufficient as a resist underlayer film, which requires heat resistance (for example, resistance to a heat treatment that is performed after the formation of a resist underlayer film in some cases).

CITATION LIST

PATENT LITERATURE

Patent Document 1: JP2004-205685A
Patent Document 2: JP6714493B2
Patent Document 3: JP2022-529888A
Patent Document 4: JP6189758B2
Patent Document 5: JP6786391B2
Patent Document 6: JP7050137B2


SUMMARY OF INVENTION

TECHNICAL PROBLEM

The present invention has been made in view of the above-described circumstances. An object of the present invention is to provide: a method for forming a resist underlayer film that contains metal and that exhibits both high filling property and high dry etching resistance; and a patterning process using the method.

SOLUTION TO PROBLEM

To achieve the object, the present invention provides a method for forming a resist underlayer film, comprising the steps of:

(i) coating a substrate with a composition for forming a resist underlayer film containing a metal compound having a metal-oxygen covalent bond and an organic solvent;
(ii) forming a cured film by heating the coated substrate at a temperature of 100°C or higher and 600°C or lower for 10 seconds to 7,200 seconds for curing; and
(iii) forming a resist underlayer film by irradiating the cured film with plasma, wherein
a compound containing at least one crosslinking group represented by the following general formulae (a-1) to (a-4), (b-1) to (b-4), and (c-1) to (c-3) is used as the metal compound,

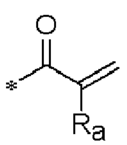
(a-1)

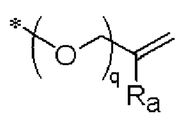
(a-2)

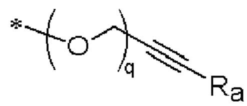
(a-3)

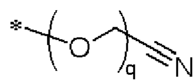
(a-4)

wherein $R_a$ represents a hydrogen atom or a monovalent organic group having 1 to 10 carbon atoms, "q" represents 0 or 1, and "*" represents an attachment point,

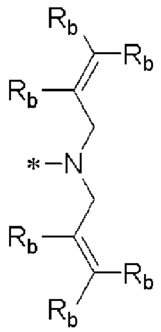
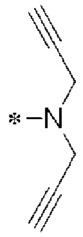
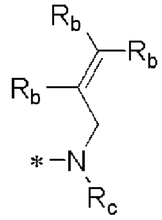
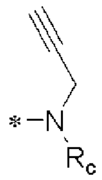

(b-1) (b-2) (b-3) (b-4)

wherein $R_b$s represent a hydrogen atom or a methyl group and are identical to or different from each other in a single formula, $R_c$ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point,

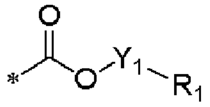
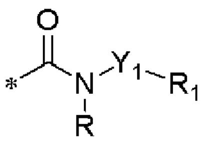
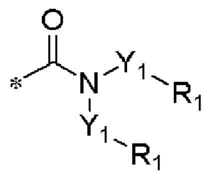

(c-1) (c-2) (c-3)

wherein $Y_1$ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, $R_1$ represents an organic group whose protecting group is to be removed by an action of an acid, heat, or both to generate one or more hydroxy groups or carboxy groups, $R_1$ being represented by one of the following general formulae (1), and "*" represents an attachment point,

$R_1$ =

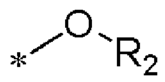
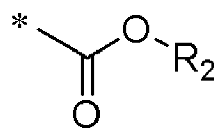

(1)

wherein $R_2$ represents an organic group whose protecting group is to be removed by an action of an acid, heat, or both, and "*" represents an attachment point to $Y_1$.

Such a method for forming a resist underlayer film can greatly improve the dry etching resistance of a metal-containing material having excellent filling property, and makes it possible to form a resist underlayer film that contains a metal and that can achieve both high filling property and high dry etching resistance, which are difficult to achieve by conventional techniques.

In the present invention, $N_2$, $NF_3$, $H_2$, a fluorocarbon, a rare gas, or a mixed gas thereof is preferably used in the step (iii).

By performing plasma irradiation using such a gas, dry etching resistance can be enhanced without degradation of the filling property of the resist underlayer film.

In this event, a gas containing $H_2$ gas is preferably used in the step (iii).

By performing plasma irradiation using a gas containing $H_2$ gas, dry etching resistance can be enhanced further without degradation of the filling property of the resist underlayer film.

In this event, a gas containing helium gas is preferably used in the step (iii).

By performing plasma irradiation using a gas containing helium gas, dry etching resistance can be enhanced further without degradation of the filling property of the resist underlayer film.

In the present invention, the cured film is preferably formed by heating in an atmosphere having an oxygen concentration of 1 volume % or more and 21 volume % or less in the step (ii).

By performing a heat treatment at such an oxygen concentration, it is possible to improve the thermosetting property of the resist underlayer film, and a resist underlayer film excellent in dry etching resistance can be formed.

In the present invention, the cured film is preferably formed by heating in an atmosphere having an oxygen concentration of less than 1 volume % in the step (ii) .

By performing a heat treatment at such an oxygen concentration, it is possible to suppress the oxidation or thermal decomposition of the resist underlayer film, and a resist underlayer film excellent in filling property can be formed.

In the present invention, the cured film is preferably formed by heating at a temperature of 100°C or higher and 450°C or lower for 10 seconds to 7,200 seconds for curing in the step (ii).

By performing a heat treatment at such a temperature, it is possible to suppress the oxidation or thermal decomposition of the resist underlayer film, and a resist underlayer film excellent in filling property can be formed.

In the present invention, the metal contained in the metal compound is preferably titanium, zirconium, hafnium, or a combination thereof.

When a metal mentioned above is contained, the dry etching resistance at the time of substrate processing can be improved further.

In the present invention, a compound containing a ligand derived from a silicon compound represented by the following general formula (2) is preferably further used as the metal compound,

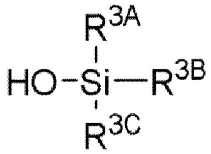
(2)

wherein $R^{3A}$, $R^{3B}$, and $R^{3C}$ each represent any organic group selected from an organic group having 2 to 30 carbon atoms and having any crosslinking group of a structure represented by the following general formulae (d-1) to (d-3), a substituted or unsubstituted alkyl group having 1 to 20 carbon atoms, and an aryl group having 6 to 20 carbon atoms,

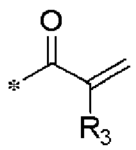
(d-1)

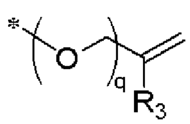
(d-2)

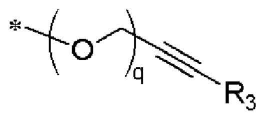
(d-3)

wherein $R_3$ represents a hydrogen atom or a monovalent organic group having 1 to 10 carbon atoms, "q" represents 0 or 1, and "*" represents an attachment point.

According to the method for forming a resist underlayer film, using the metal compound containing the silicon compound, it is possible to form a resist underlayer film having better filling property.

The present invention also provides a patterning process for forming a pattern in a substrate to be processed, comprising the steps of:

(I-1) forming a resist underlayer film on a substrate to be processed by the above-described method for forming a resist underlayer film;
(I-2) forming a silicon-containing resist middle layer film on the resist underlayer film;
(I-3) forming a resist upper layer film on the silicon-containing resist middle layer film by using a photoresist material;
(I-4) subjecting the resist upper layer film to pattern exposure and then development with a developer to form a pattern in the resist upper layer film;
(I-5) transferring the pattern to the silicon-containing resist middle layer film by dry etching while using the resist upper layer film having the formed pattern as a mask;

(I-6) transferring the pattern to the resist underlayer film by dry etching while using the silicon-containing resist middle layer film having the transferred pattern as a mask; and
(I-7) processing the substrate to be processed while using the resist underlayer film having the formed pattern as a mask to form the pattern in the substrate to be processed.

The patterning process makes it possible to form fine patterns on the body to be processed with high precision.
The present invention also provides a patterning process for forming a pattern in a substrate to be processed, comprising the steps of:

(II-1) forming a resist underlayer film on a substrate to be processed by the above-described method for forming a resist underlayer film;
(II-2) forming an inorganic hard mask middle layer film selected from the group consisting of a silicon oxide film, a silicon nitride film, and a silicon oxynitride film on the resist underlayer film;
(II-3) forming an organic thin film on the inorganic hard mask middle layer film;
(II-4) forming a resist upper layer film on the organic thin film by using a photoresist material;
(II-5) subjecting the resist upper layer film to pattern exposure and then development with a developer to form a pattern in the resist upper layer film;
(II-6) transferring the pattern to the organic thin film and the inorganic hard mask middle layer film by dry etching while using the resist upper layer film having the formed pattern as a mask;
(II-7) transferring the pattern to the resist underlayer film by dry etching while using the inorganic hard mask middle layer film having the transferred pattern as a mask; and
(II-8) processing the substrate to be processed while using the resist underlayer film having the formed pattern as a mask to form the pattern in the substrate to be processed.

The patterning process makes it possible to form fine patterns on the body to be processed with a high degree of accuracy.
The present invention also provides a patterning process for forming a pattern in a substrate to be processed, comprising the steps of:

(III-1) forming a resist underlayer film on a substrate to be processed by the above-described method for forming a resist underlayer film;
(III-2) forming an organic middle layer film on the resist underlayer film;
(III-3) forming a silicon-containing resist middle layer film or a combination of an inorganic hard mask middle layer film selected from the group consisting of a silicon oxide film, a silicon nitride film, and a silicon oxynitride film and an organic thin film on the organic middle layer film;
(III-4) forming a resist upper layer film on the silicon-containing resist middle layer film or the organic thin film by using a photoresist material;
(III-5) subjecting the resist upper layer film to pattern exposure and then development with a developer to form a pattern in the resist upper layer film;
(III-6) transferring the pattern to the silicon-containing resist middle layer film or the organic thin film and the inorganic hard mask middle layer film by dry etching while using the resist upper layer film having the formed pattern as a mask;
(III-7) transferring the pattern to the organic middle layer film by dry etching while using the silicon-containing resist middle layer film or the inorganic hard mask middle layer film having the transferred pattern as a mask;
(III-8) transferring the pattern to the resist underlayer film by dry etching while using the organic middle layer film having the transferred pattern as a mask; and
(III-9) processing the substrate to be processed while using the resist underlayer film having the formed pattern as a mask to form the pattern in the substrate to be processed.

The patterning process makes it possible to form fine patterns on the body to be processed with a high degree of accuracy.
The present invention also provides a method for forming a resist underlayer film, comprising the steps of:

(i') coating a substrate with a composition for forming a resist underlayer film containing a metal belonging to the third period to the seventh period and the group III to the group XV of the periodic table;
(ii) forming a cured film by heating the coated substrate at a temperature of 100°C or higher and 600°C or lower for 10 seconds to 7,200 seconds for curing; and
(iii) forming a resist underlayer film by irradiating the cured film with plasma.

Such a method for forming a resist underlayer film can greatly improve the dry etching resistance of a metal-containing material, and makes it possible to form a resist underlayer film that can achieve both high filling property and high dry etching resistance, which are difficult to achieve by conventional techniques.
In this event, a composition containing a metal compound having a metal-oxygen covalent bond or containing a metal compound having a metal-carbon covalent bond is preferably used as the composition for forming a resist underlayer film.
Such a method for forming a resist underlayer film makes it possible to form a resist underlayer film that can achieve both high filling property and high dry etching resistance, which are difficult to achieve by conventional techniques.

ADVANTAGEOUS EFFECTS OF INVENTION

As described above, the inventive methods for forming a resist underlayer film and patterning processes are particularly suitably employed in multilayer resist processes that include the filling and planarization of a stepped or uneven substrate to be processed, and are extremely useful in fine patterning for manufacturing a semiconductor device. In particular, in a fine patterning process using a multilayer resist method in a semiconductor device manufacturing process, filling is possible without causing defects such as voids and peeling even on a substrate to be processed having a portion that is difficult to fill and planarize, such as a dense portion of a fine pattern structure having a high aspect ratio exemplified by increasingly miniaturized DRAM. Thus, a resist underlayer film having excellent planarizing property can be formed. Furthermore, better etching resistance can be exhibited compared to conventional methods for forming a resist underlayer film, and in particular, by performing plasma irradiation, the advantageous effects can be exhibited. Therefore, a fine pattern can be formed on a body to be processed with even higher precision.

BRIEF DESCRIPTION OF DRAWINGS

FIG. 1 is an explanatory view of an example (three-layer resist process) of the patterning process of the present invention.
FIG. 2 is an explanatory view of a method for evaluating the filling property.

DESCRIPTION OF EMBODIMENTS

As stated above, there have been demands for the development of: a method for forming a resist underlayer film that makes it possible to transfer a resist pattern to a substrate to be processed with higher precision in a fine patterning process according to a multilayer resist method; and a patterning process using the method for forming a resist underlayer film.
Generally, metal oxide compounds undergo great thermal shrinkage during baking, and this induces considerable degradation in filling property after high-temperature baking. Patent Document 5, which, therefore, causes concerns of being inadequate for resist underlayer film materials, which are required to have high planarizing and filling properties and heat resistance, reports a metal-containing material excellent in filling property. However, since the material contains many organic components, it is thought that dry etching resistance at the time of substrate processing, which is a strength of metal materials, is insufficient. The filling property and dry etching resistance of a metal material are in a trade-off relationship, and a breakthrough has been necessary.
The present inventors have hypothesized that by promoting, by plasma irradiation, the dissociation and rebonding of carbon bonds contained in a metal-containing film whose steps have been filled, it may be possible to improve dry etching resistance without the filling property being degraded, and studied earnestly. As a result, the present inventors have found out that, according to a method for forming a resist underlayer film including subjecting a metal-containing resist underlayer film to plasma irradiation, it is possible to improve greatly the dry etching resistance at the time of substrate processing without the degradation of filling property. Thus, the present invention has been completed.
That is, the present invention is a method for forming a resist underlayer film, comprising the steps of:

(i) coating a substrate with a composition for forming a resist underlayer film containing a metal compound having a metal-oxygen covalent bond and an organic solvent;
(ii) forming a cured film by heating the coated substrate at a temperature of 100°C or higher and 600°C or lower for 10 seconds to 7,200 seconds for curing; and
(iii) forming a resist underlayer film by irradiating the cured film with plasma, wherein
a compound containing at least one crosslinking group represented by the following general formulae (a-1) to (a-4), (b-1) to (b-4), and (c-1) to (c-3) is used as the metal compound,

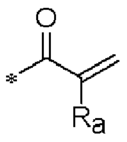

(a-1)

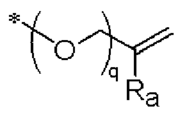

(a-2)

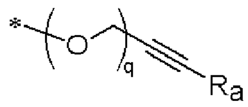

(a-3)

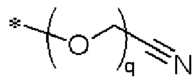

(a-4)

wherein $R_a$ represents a hydrogen atom or a monovalent organic group having 1 to 10 carbon atoms, "q" represents 0 or 1, and "*" represents an attachment point,

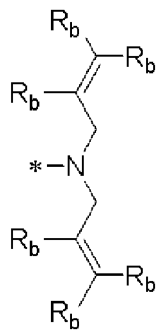

(b-1)

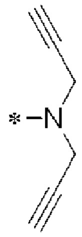

(b-2)

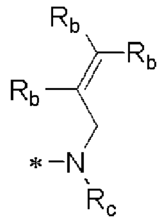

(b-3)

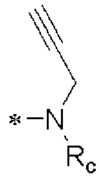

(b-4)

wherein $R_b$s represent a hydrogen atom or a methyl group and are identical to or different from each other in a single formula, $R_c$ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point,

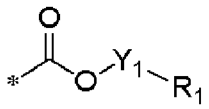

(c-1)

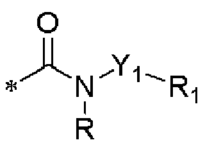

(c-2)

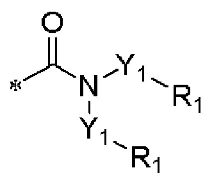

(c-3)

wherein $Y_1$ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, $R_1$ represents an organic group whose protecting group is to be removed by an action of an acid, heat, or both to generate one or more hydroxy groups or carboxy groups, $R_1$ being represented by one of the following general formulae (1), and "*" represents an attachment point,

$R_1$ =

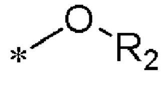

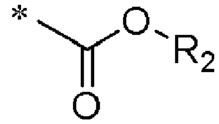

(1)

wherein $R_2$ represents an organic group whose protecting group is to be removed by an action of an acid, heat, or both, and "*" represents an attachment point to $Y_1$.

In addition, the present invention is a method for forming a resist underlayer film, comprising the steps of:

(i') coating a substrate with a composition for forming a resist underlayer film containing a metal belonging to the third period to the seventh period and the group III to the group XV of the periodic table;
(ii) forming a cured film by heating the coated substrate at a temperature of 100°C or higher and 600°C or lower for 10 seconds to 7,200 seconds for curing; and
(iii) forming a resist underlayer film by irradiating the cured film with plasma.

Hereinafter, the present invention will be described in detail, but the present invention is not limited thereto.

<Method for Forming Resist Underlayer Film>

The present invention is a method for forming a resist underlayer film, including the steps of:

(i') coating a substrate with a composition for forming a resist underlayer film containing a metal belonging to the third period to the seventh period and the group III to the group XV of the periodic table;
(ii) forming a cured film by heating the coated substrate at a temperature of 100°C or higher and 600°C or lower for 10 seconds to 7,200 seconds for curing; and
(iii) forming a resist underlayer film by irradiating the cured film with plasma.

According to such a method for forming a resist underlayer film, it is possible to form a resist underlayer film excellent in etching resistance during substrate processing without degrading filling property.

In this event, a composition containing a metal compound having a metal-oxygen covalent bond or containing a metal compound having a metal-carbon covalent bond is preferably used as the composition for forming a resist underlayer film.

According to such a method for forming a resist underlayer film, the composition includes a structure in which ligands are coordinated to the metal atom via an oxygen atom or a carbon atom, and therefore, film modification by plasma irradiation is more easily promoted.

In addition, the present invention is a method for forming a resist underlayer film, including the steps of:

(i) coating a substrate with a composition for forming a resist underlayer film containing a metal compound having a metal-oxygen covalent bond and an organic solvent;
(ii) forming a cured film by heating the coated substrate at a temperature of 100°C or higher and 600°C or lower for 10 seconds to 7,200 seconds for curing; and
(iii) forming a resist underlayer film by irradiating the cured film with plasma, where
a compound containing at least one crosslinking group represented by the following general formulae (a-1) to (a-4), (b-1) to (b-4), and (c-1) to (c-3) is used as the metal compound.

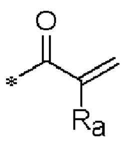
(a-1)

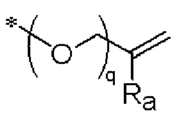
(a-2)

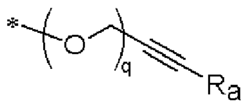
(a-3)

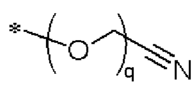
(a-4)

In the general formulae (a-1) to (a-4), $R_a$ represents a hydrogen atom or a monovalent organic group having 1 to 10 carbon atoms, "q" represents 0 or 1, and "*" represents an attachment point.

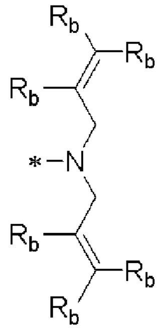 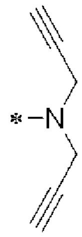 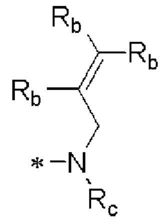 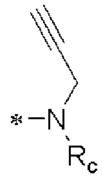

(b-1) (b-2) (b-3) (b-4)

In the general formulae (b-1) to (b-4), $R_b$s represent a hydrogen atom or a methyl group and are identical to or different from each other in a single formula, $R_c$ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point.

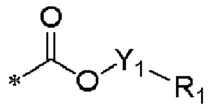 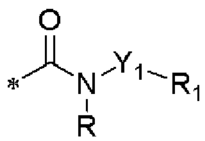 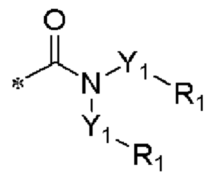

(c-1) (c-2) (c-3)

In the general formulae (c-1) to (c-3), $Y_1$ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, $R_1$ represents an organic group whose protecting group is to be removed by an action of an acid, heat, or both to generate one or more hydroxy groups or carboxy groups, $R_1$ being represented by one of the following general formulae (1), and "*" represents an attachment point.

$R_1$ = 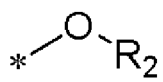 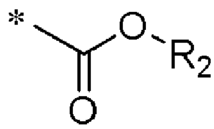 (1)

In the general formulae (1), $R_2$ represents an organic group whose protecting group is to be removed by an action of an acid, heat, or both, and "*" represents an attachment point to $Y_1$.

According to such a method for forming a resist underlayer film, it is possible to form a resist underlayer film excellent in etching resistance during substrate processing without degrading filling property.

As the gas atmosphere in the step (iii), it is preferable to use $N_2$, $NF_3$, $H_2$, a fluorocarbon, a rare gas, or a mixed gas of any of these gases, and suitable examples include helium, Ar, $N_2$, Ne, $NF_3$, $H_2$, $CF_4$, $CHF_3$, $CH_2F_2$, $CH_3F$, $C_4F_6$, $C_4F_8$, etc. Two or more of these gases may also be used in mixture.

From the viewpoint of productivity, more preferable gas atmospheres include helium, Ar, $N_2$, $H_2$, etc., and it is further preferable to use a gas containing helium gas or $H_2$ gas.

For the irradiation with plasma, a known method can be employed. Examples include methods disclosed in JP5746670B2 (Patent Document) and "Improvement of the wiggling profile of spin-on carbon hard mask by H2 plasma treatment" (J. Vac. Sci. Technol. B26 (1), Jan/Feb 2008, pp. 67-71, Non Patent Document).

The RF discharge power during the plasma irradiation can be selected from 100 to 10,000 W, and is more suitably 200 to 5,000 W.

The plasma irradiation time can be selected from 10 to 300 seconds. The pressure can be selected appropriately.

The irradiation apparatus is not particularly limited as long as the apparatus can perform plasma irradiation, and for example, Telius SP, Tactras Vigus manufactured by Tokyo Electron Ltd. or the like are usable. It is possible to select an apparatus and set conditions so as to achieve the advantageous effects of the present invention.

In the step (ii), the baking temperature for curing the film is 100°C or higher and 600°C or lower, preferably 100°C or higher and 500°C or lower, further preferably 100°C or higher and 450°C or lower. The baking time is in the range of 10 seconds to 7,200 seconds, preferably 30 seconds to 600 seconds, and particularly preferably 45 seconds to 240 seconds.

By adjusting the baking temperature and time appropriately within the above-described ranges, it is possible to achieve the planarizing and filling properties and curing properties, such as dry etching resistance and heat resistance, suitable for the intended usage. By performing the baking within the temperature range of 100°C or higher to 600°C or lower, a state in which many active spots, where the dissociation and rebonding of carbon bonds in the cured film occur, are contained in the film is achieved without degrading the filling property. Accordingly, film modification due to plasma irradiation or electron beam irradiation is facilitated, and therefore, it is possible to form a resist underlayer film excellent in dry etching resistance. If the baking temperature is lower than 100°C, the solvent remaining in the film cannot be reduced, and degradation of film thickness uniformity due to plasma irradiation or electron beam irradiation occurs. If the baking temperature exceeds 600°C, crystallization of the cured film cannot be suppressed. The heating can also be performed in a plurality of steps (step baking).

A baking time of less than 10 seconds is unfavorable since there is risk of the curing being uneven, and a baking time exceeding 7,200 seconds is unfavorable from the viewpoint of productivity.

Furthermore, in the step (ii), it is favorable to form the cured film by heat-treating the substrate coated with the composition for forming a resist underlayer film in an atmosphere having an oxygen concentration of 1% or more and 21% or less.

Alternatively, in the step (ii), it is favorable to form the cured film by heat-treating the substrate coated with the composition for forming a resist underlayer film in an atmosphere having an oxygen concentration of less than 1%.

By performing the heating at the above-described oxygen concentrations, rapid volume shrinkage of the cured film can be suppressed and organic components in the cured film can be removed mildly, and therefore, dry etching resistance can be enhanced without degrading the filling property. Furthermore, in a case where the substrate to be processed easily undergoes air oxidation, damage to the substrate can be suppressed by forming the cured film through a heat treatment in an atmosphere having an oxygen concentration of less than 1%. In such a case, at the time of heating, the treatment is preferably performed in an atmosphere having an oxygen concentration of less than 1%, particularly preferably 0.1% or less, more preferably 0.01% or less, and further preferably 0.005% or less.

As the atmosphere at the time of baking, it is possible to select either an oxygen-containing atmosphere such as air (oxygen concentration: 1% to 21%) or a non-oxygen atmosphere such as nitrogen as necessary.

In a case where heating is to be performed after the plasma irradiation, the heating conditions are appropriately selected from a range of, regarding heating temperature, 100 to 800°C (preferably 150 to 700°C, more preferably 200 to 600°C) and, regarding heating time, 10 to 7,200 seconds (preferably 30 to 300 seconds, more preferably 45 to 180 seconds). Although there is no restriction to theories, it is thought that, by performing high-temperature heating after the plasma irradiation, it is possible to allow dangling bonds to be bonded, and thus contribute to the densification of the resist underlayer film.

As the atmosphere for the heating after the plasma irradiation, it is possible to select either an oxygen-containing atmosphere such as air (oxygen concentration: 1% to 21%) or a non-oxygen atmosphere such as nitrogen as necessary.

In the patterning process using the composition for forming a resist underlayer film used in the inventive method for forming a resist underlayer film, it is preferable to use a substrate to be processed having a structure or step having a height of 30 nm or more. As described above, the composition for forming a resist underlayer film used in the inventive method for forming a resist underlayer film has excellent filling and planarizing properties, so that a flat resist underlayer film can be formed even when the substrate to be processed has a step (irregularities) or structure having a height of 30 nm or more. The height of the structure or step of the substrate to be processed is preferably 30 nm or more, more preferably 50 nm or more, and further preferably 100 nm or more. In the method of processing a stepped substrate having a pattern of the above-described height, filling and planarizing by forming a film of the composition for forming a resist underlayer film used in the inventive method for forming a resist underlayer film makes it possible to achieve a uniform film thickness in the subsequently formed resist middle layer film and resist upper layer film. Therefore, it is easy to ensure the exposure depth margin (DOF) at the time of photolithography, which is very desirable.

<Composition for Forming Resist Underlayer Film>

The composition for forming a resist underlayer film used in the inventive method for forming a resist underlayer film contains a metal belonging to the third period to the seventh period and the group III to the group XV of the periodic

table.

Examples of metals belonging to the third period to the seventh period and the group III to the group XV of the periodic table include:

as metals of the group III, scandium, yttrium, lanthanum, cerium, etc.;
as metals of the group IV, titanium, zirconium, hafnium, etc.;
as metals of the group V, vanadium, niobium, tantalum, etc.;
as metals of the group VI, chromium, molybdenum, tungsten, etc.;
as metals of the group VII, manganese, rhenium, etc.;
as metals of the group VIII, iron, ruthenium, osmium, etc.;
as metals of the group IX, cobalt, rhodium, iridium, etc.;
as metals of the group X, nickel, palladium, platinum, etc.;
as metals of the group XI, copper, silver, gold, etc.;
as metals of the group XII, zinc, cadmium, mercury, etc.;
as metals of the group XIII, aluminum, gallium, indium, etc.;
as metals of the group XIV, germanium, tin, lead, etc.; and
as metals of the group XV, antimony, bismuth, etc.

The metals of the group IV to the group VI and the group XIII to the group XV are more preferable, and titanium, zirconium, and hafnium are further preferable.

Such a composition for forming a resist underlayer film can provide, when irradiated with plasma, a resist underlayer film that exhibits outstanding dry etching resistance. According to the inventive method for forming a resist underlayer film, the dry etching resistance can be enhanced without degrading the filling property of the resist underlayer film.

In addition, as the composition for forming a resist underlayer film, it is preferable to use a composition containing a metal compound having a metal-oxygen covalent bond or containing a metal compound having a metal-carbon covalent bond.

According to such a method for forming a resist underlayer film, there is a structure in which ligands are coordinated to the metal atom via an oxygen atom or a carbon atom, and therefore, film modification due to plasma irradiation is more easily promoted.

In addition, the composition for forming a resist underlayer film to be used in the inventive method for forming a resist underlayer film contains (A) a metal compound and (B) an organic solvent.

Such a composition for forming a resist underlayer film contains a metal compound that has both high thermal flowability and high thermosetting property, and therefore, exhibits high filling and planarizing properties, and can provide a resist underlayer film that exhibits outstanding dry etching resistance by being subjected to plasma irradiation. According to the inventive method for forming a resist underlayer film, dry etching resistance can be improved without the filling property of the resist underlayer film being degraded.

[(A) Metal Compound]

The metal compound contained in the composition for forming a resist underlayer film used in the inventive method for forming a resist underlayer film has a metal-oxygen covalent bond and contains at least one crosslinking group represented by the following general formulae (a-1) to (a-4), (b-1) to (b-4), and (c-1) to (c-3) .

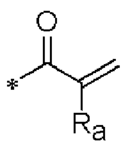
(a-1)

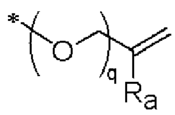
(a-2)

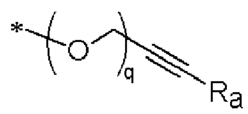
(a-3)

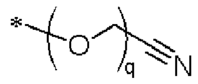
(a-4)

In the general formulae (a-1) to (a-4), $R_a$ represents a hydrogen atom or a monovalent organic group having 1 to 10 carbon atoms, "q" represents 0 or 1, and "*" represents an attachment point.

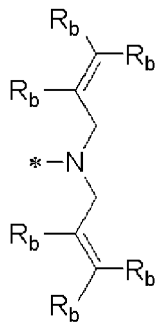 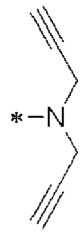 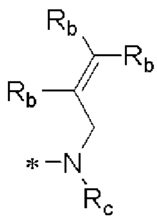 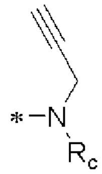

(b-1) (b-2) (b-3) (b-4)

In the general formulae (b-1) to (b-4), $R_b$s represent a hydrogen atom or a methyl group and are identical to or different from each other in a single formula, $R_c$ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point.

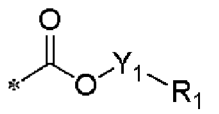 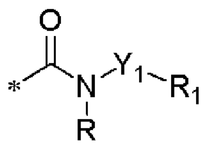 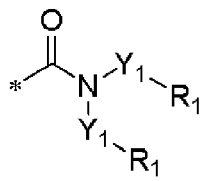

(c-1) (c-2) (c-3)

In the general formulae (c-1) to (c-3), $Y_1$ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, $R_1$ represents an organic group whose protecting group is to be removed by an action of an acid, heat, or both to generate one or more hydroxy groups or carboxy groups, $R_1$ being represented by one of the following general formulae (1), and "*" represents an attachment point.

$R_1$ = 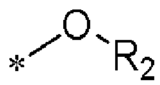 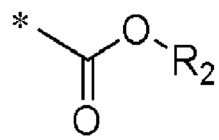 (1)

In the general formulae (1), $R_2$ represents an organic group whose protecting group is to be removed by an action of an acid, heat, or both, and "*" represents an attachment point to $Y_1$.

By the metal compound having a metal-oxygen covalent bond, high etching resistance can be achieved.

By the metal compound containing at least one crosslinking group represented by the general formulae (a-1) to (a-4), (b-1) to (b-4), and (c-1) to (c-3), a resist underlayer film having excellent filling property can be formed. Moreover, since a film excellent in heat resistance can be formed, dry etching resistance can be improved by carrying out baking within the temperature range of 100°C or higher to 600°C or lower without degrading the filling property.

Ligands coordinated to the metal compound are not particularly limited as long as one or more ligands having a crosslinking group represented by the general formulae (a-1) to (a-4), (b-1) to (b-4), and (c-1) to (c-3) are coordinated, but from the viewpoint of stability, a carboxylate, acetyl acetate, polyhydric alcohol, etc. are preferable.

Specific examples of ligands containing a crosslinking group represented by the general formulae (a-1) to (a-4) include the following compounds, but are not limited thereto.

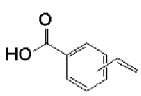
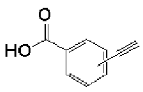
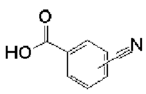
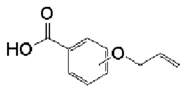
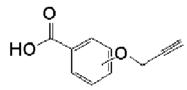

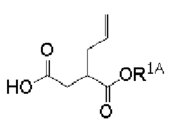
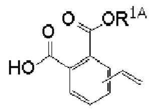
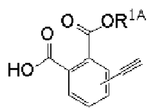
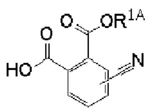
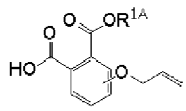
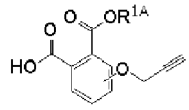

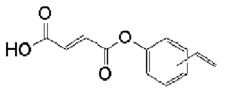
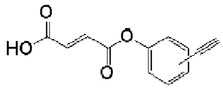
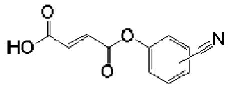
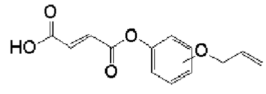

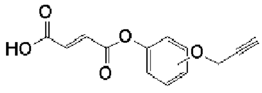
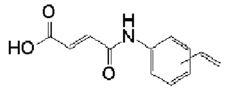
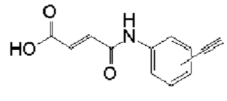
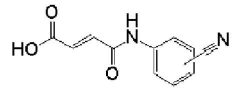

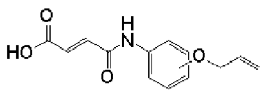
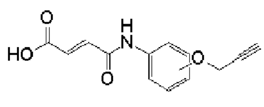
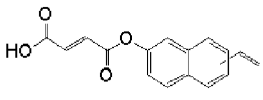
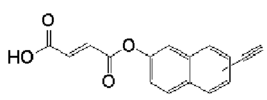

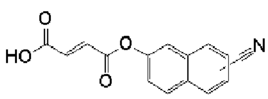
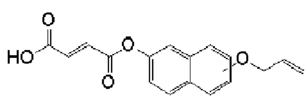
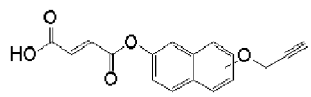

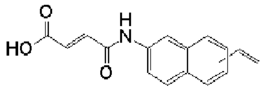
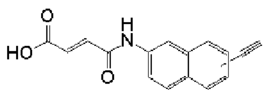
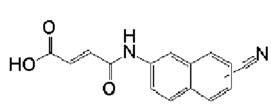
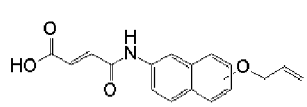

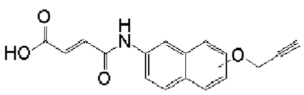
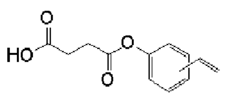
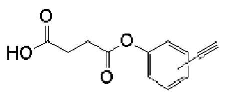
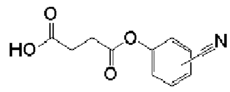

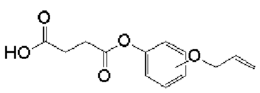
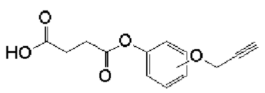
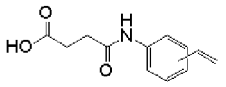
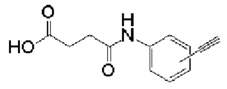

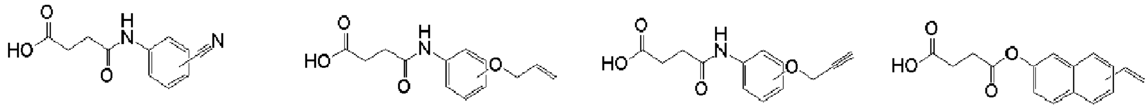

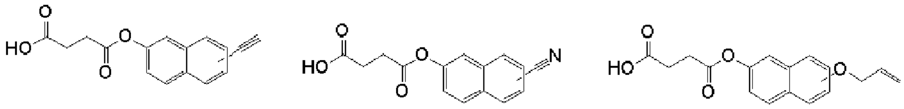

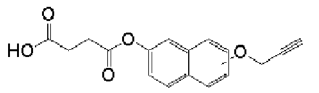 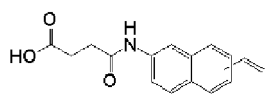 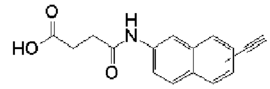

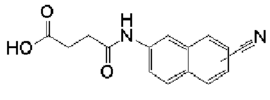 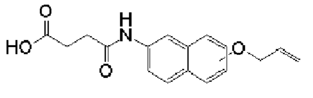 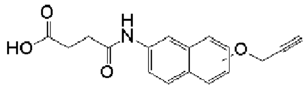

$R^{1A}$ represents any organic group selected from a substituted or unsubstituted alkyl group having 1 to 20 carbon atoms and a substituted or unsubstituted aryl group having 6 to 20 carbon atoms.

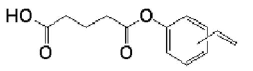 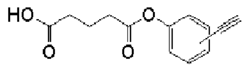 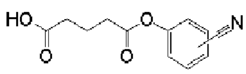 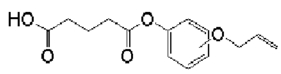

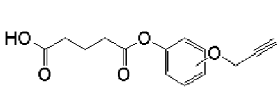 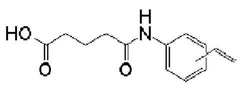 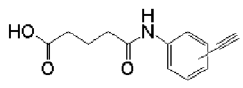 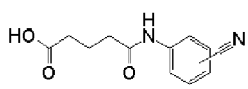

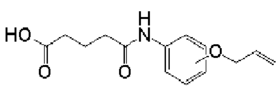 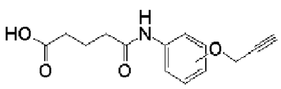 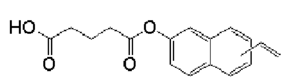 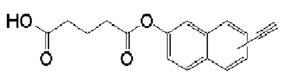

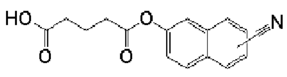 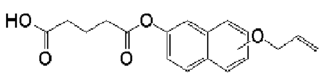 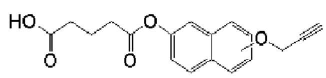

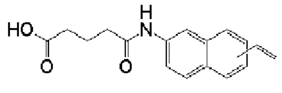 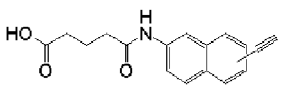 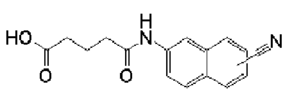

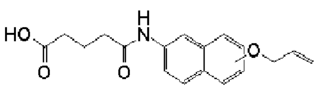 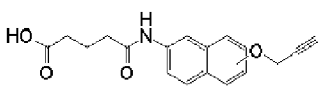 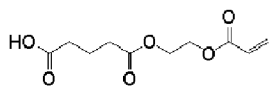

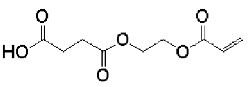 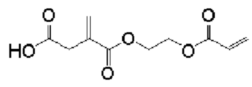 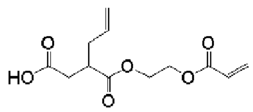 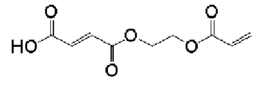

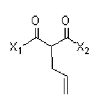 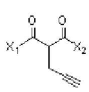 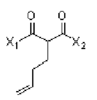 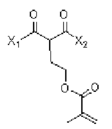 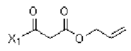 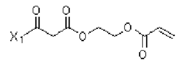 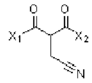

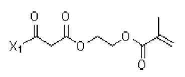 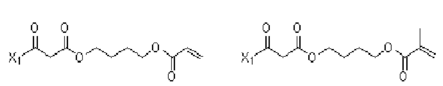

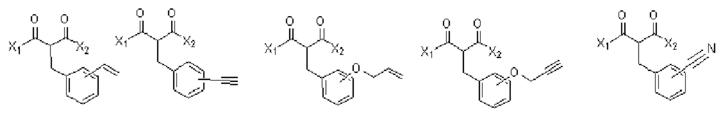

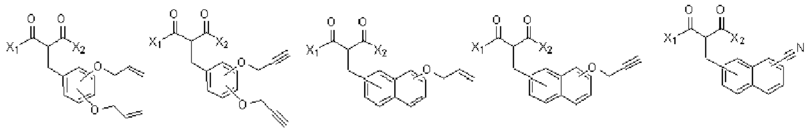

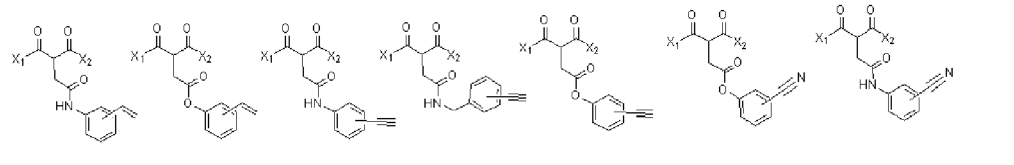

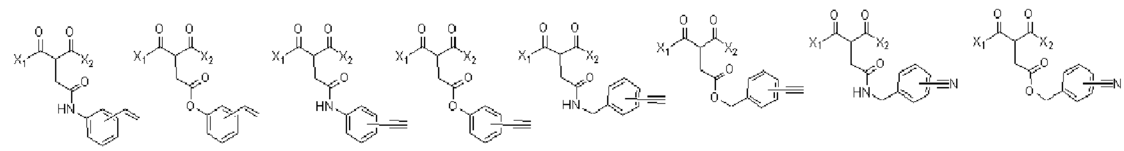

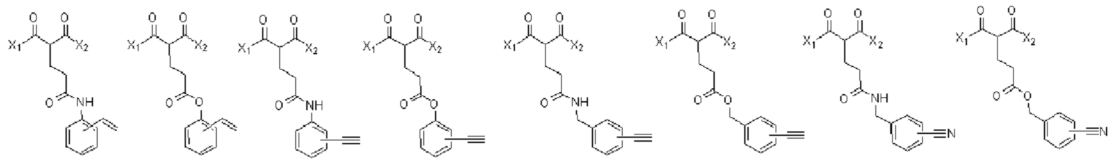

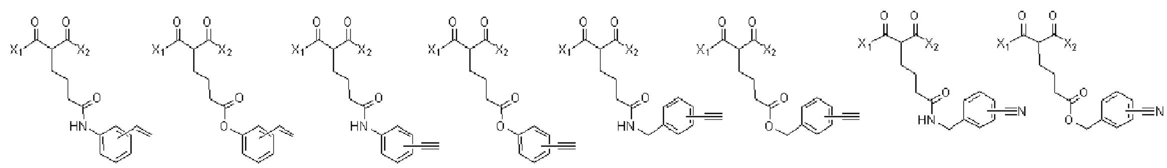

In the formulae, $X_1$ and $X_2$ each represent a hydrocarbon group having 1 to 20 carbon atoms or an alkoxy group having 1 to 20 carbon atoms.

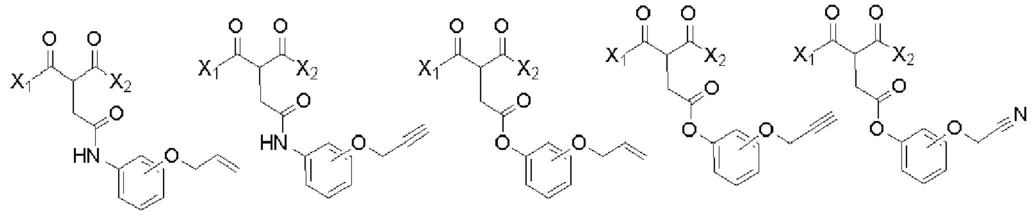

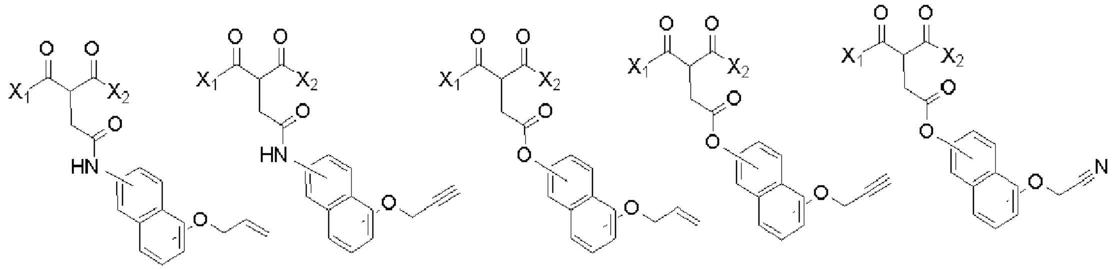

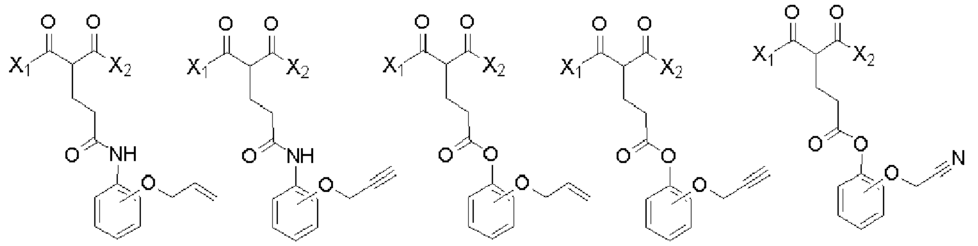

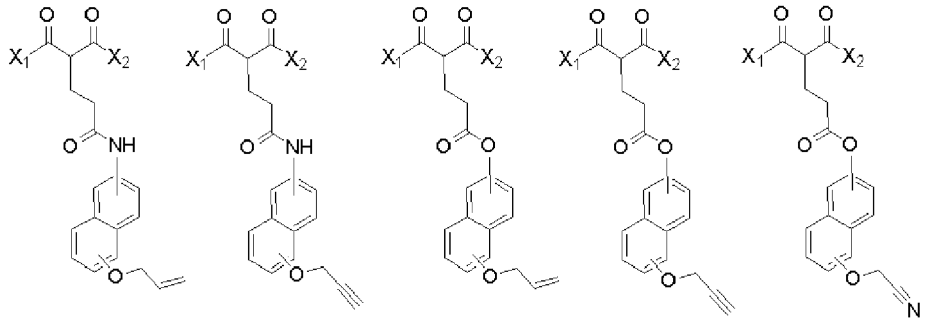

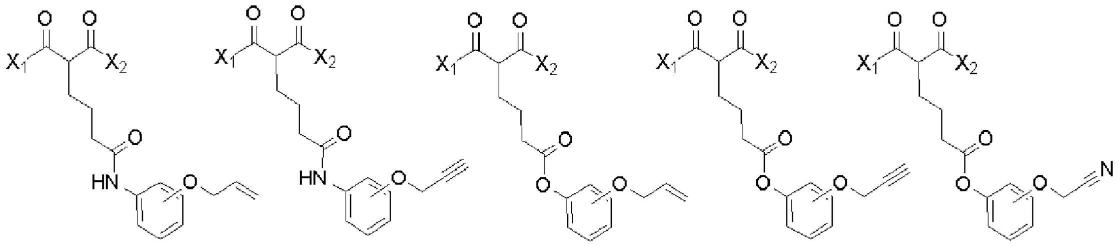

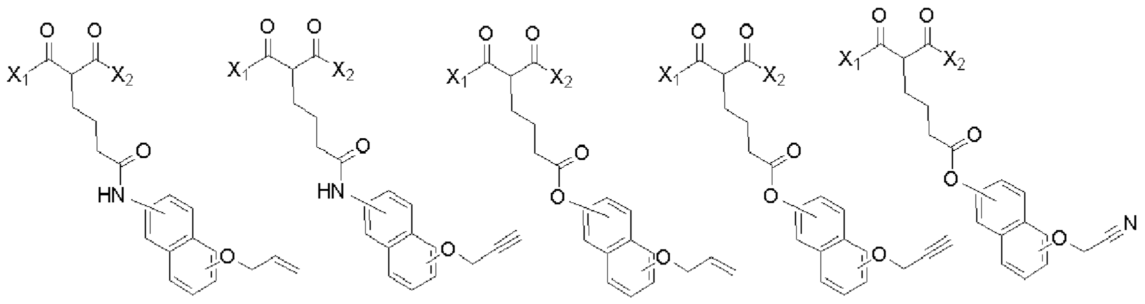

In the formulae, $X_1$ and $X_2$ each represent a hydrocarbon group having 1 to 20 carbon atoms or an alkoxy group having 1 to 20 carbon atoms.

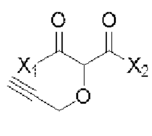
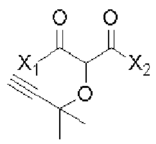
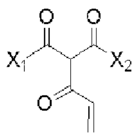
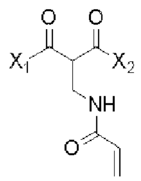
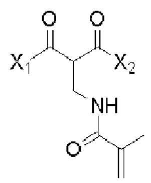
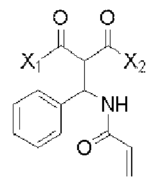

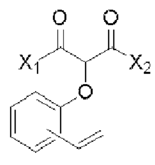
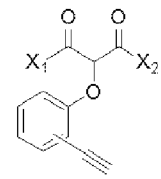
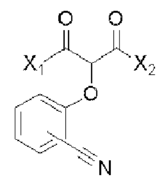
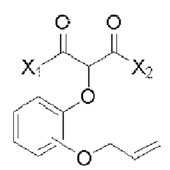
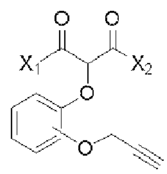

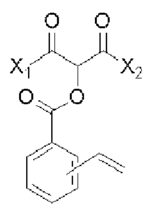 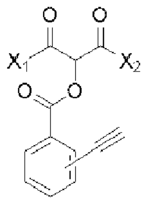 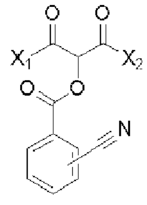 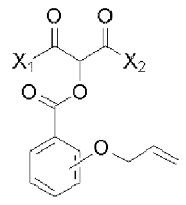 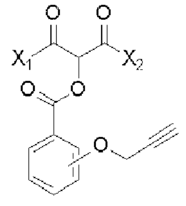

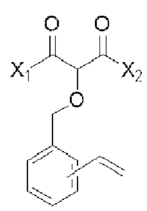 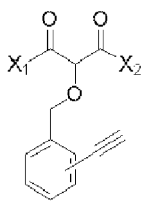 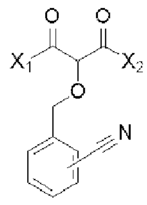 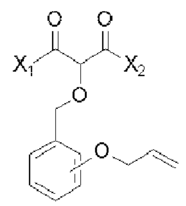 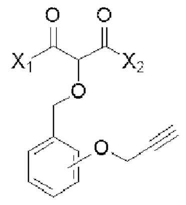

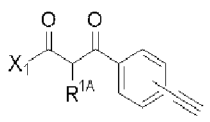 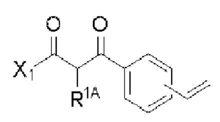 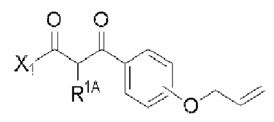 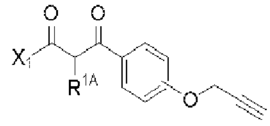

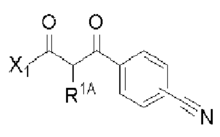 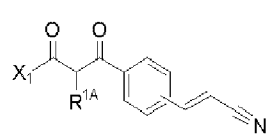 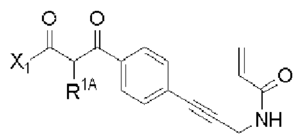

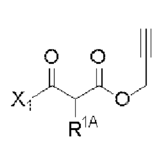 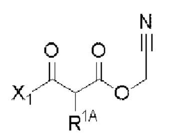 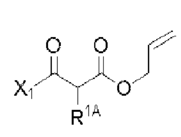 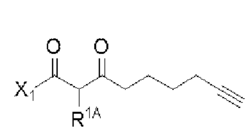

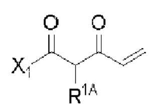 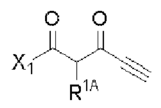 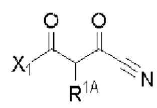

In the formulae, $R^{1A}$ represents any organic group selected from a substituted or unsubstituted alkyl group having 1 to 20 carbon atoms and a substituted or unsubstituted aryl group having 6 to 20 carbon atoms; and $X_1$ and $X_2$ each represent a hydrocarbon group having 1 to 20 carbon atoms or an alkoxy group having 1 to 20 carbon atoms.

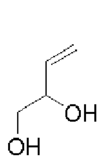 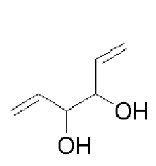 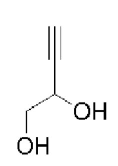 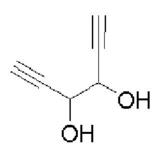 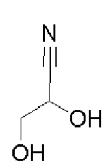 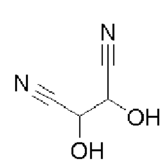

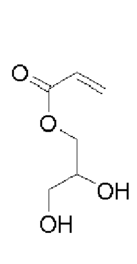 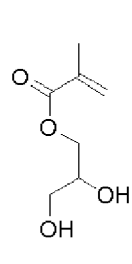 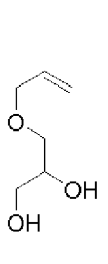 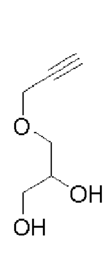 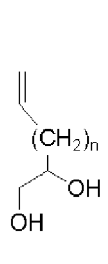 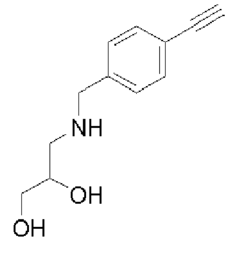

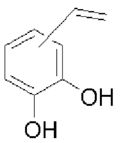 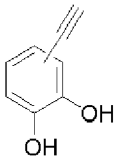 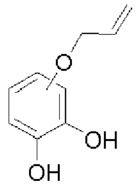 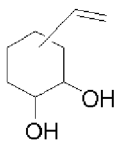 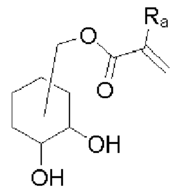 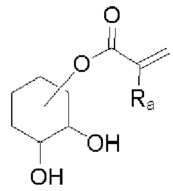

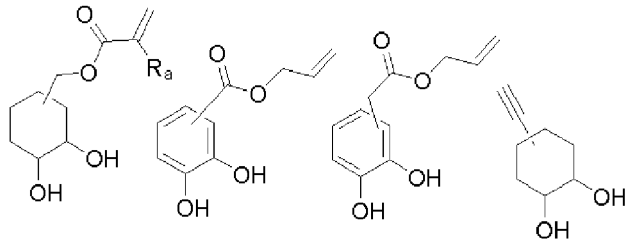 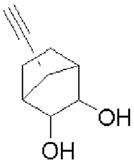 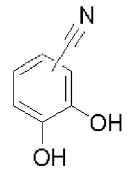 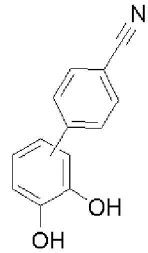

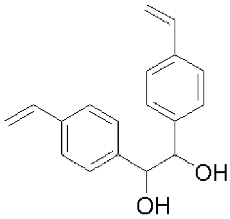 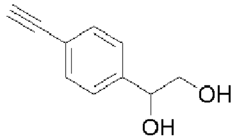 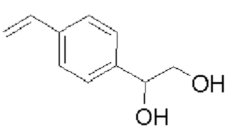 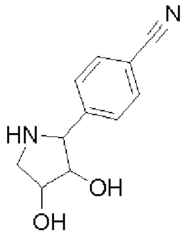 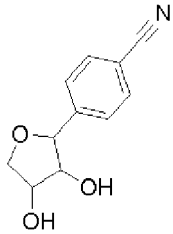

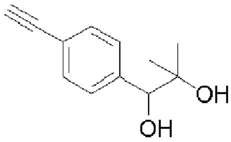 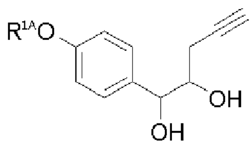 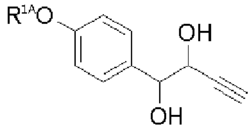 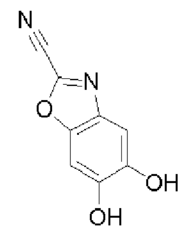 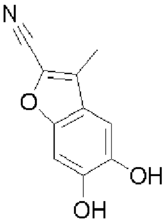

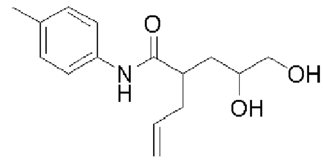 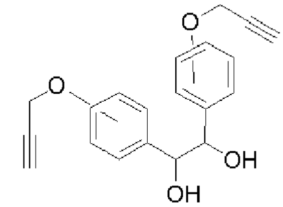 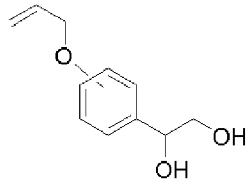 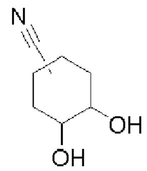

In the formulae, $R^{1A}$ represents any organic group selected from a substituted or unsubstituted alkyl group having 1 to 20 carbon atoms and an aryl group having 6 to 20 carbon atoms; and $R_a$ represents a hydrogen atom or a monovalent organic group having 1 to 10 carbon atoms.

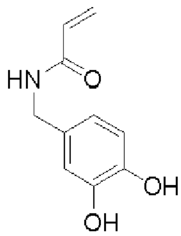 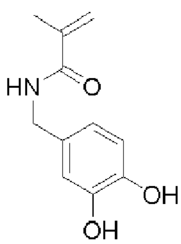 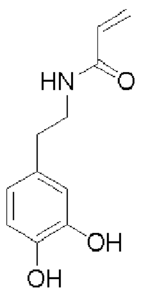 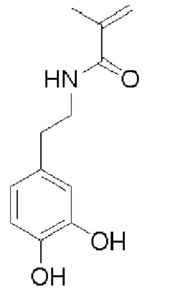 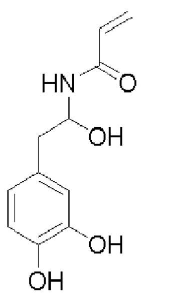 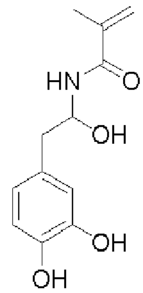

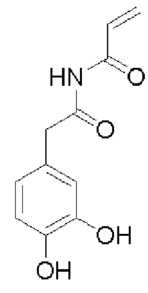
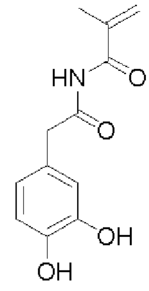
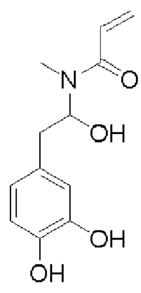
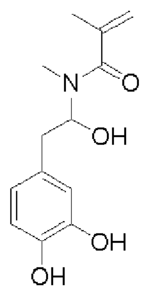
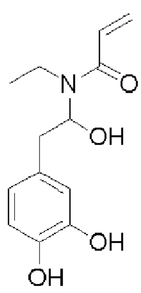
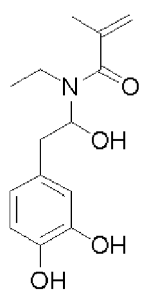

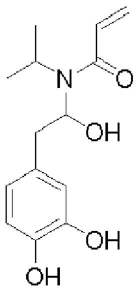
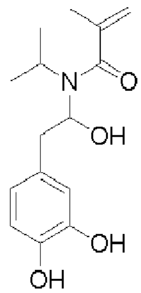
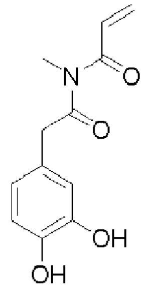
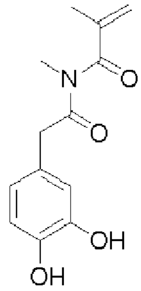
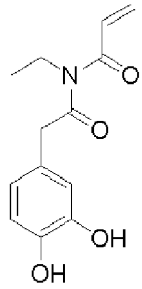
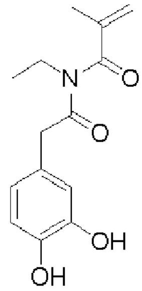

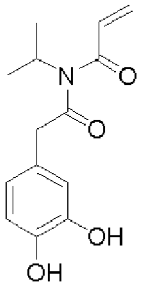
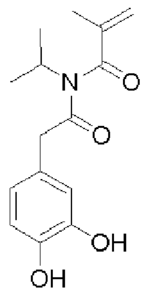

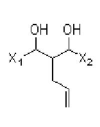
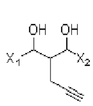
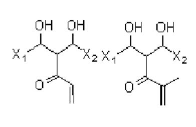
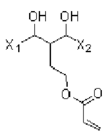
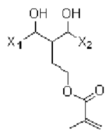
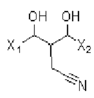

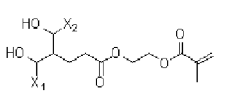
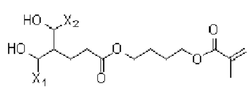
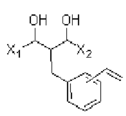
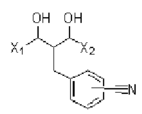

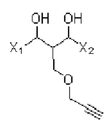
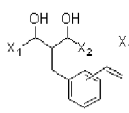
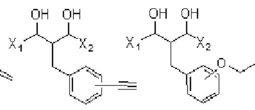
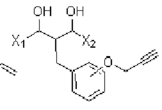
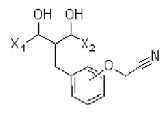

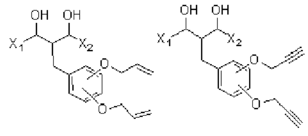
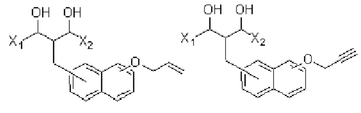
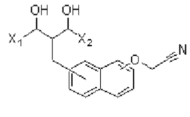

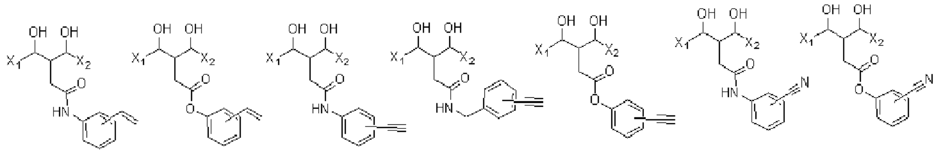

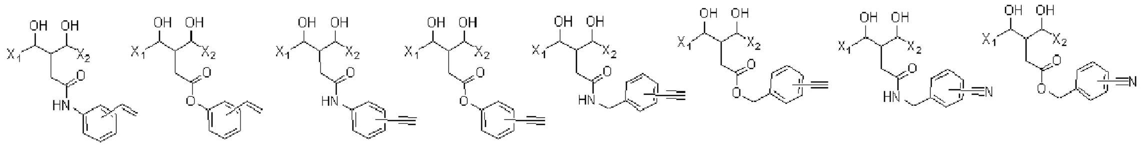

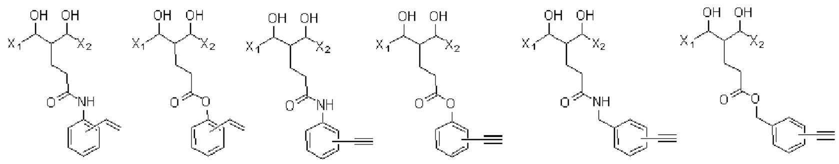

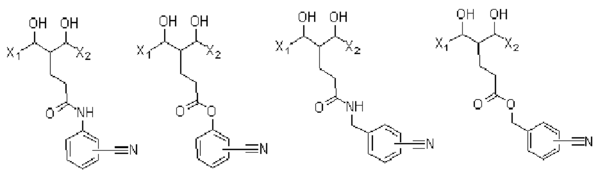

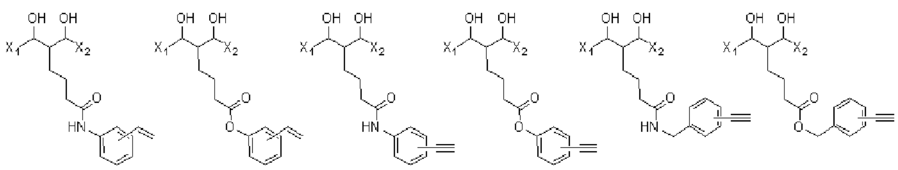

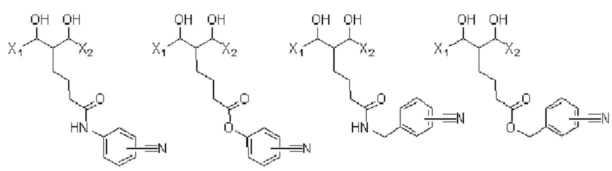

In the formulae, $X_1$ and $X_2$ each represent a hydrocarbon group having 1 to 20 carbon atoms or an alkoxy group having 1 to 20 carbon atoms.

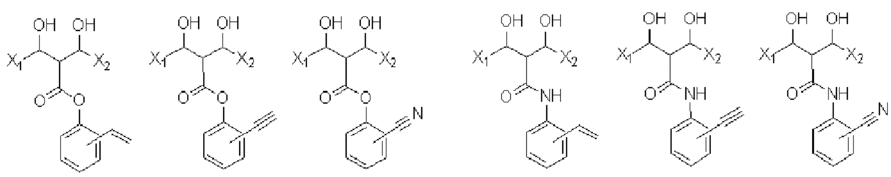

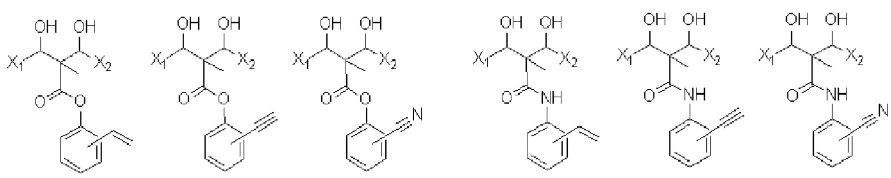

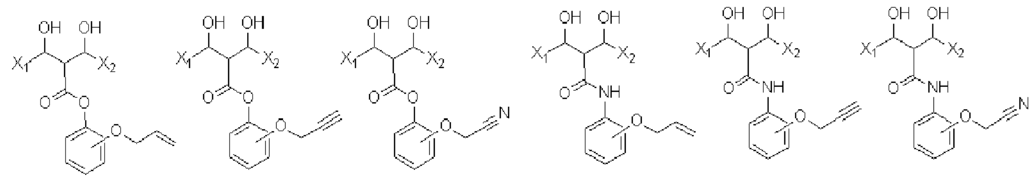

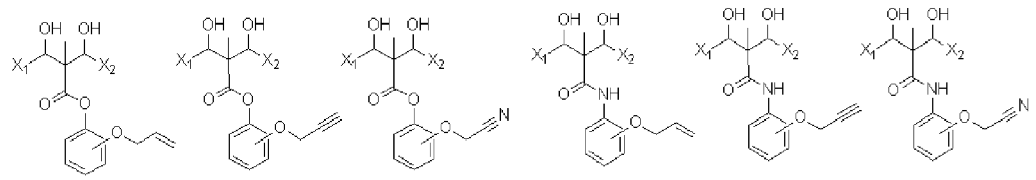

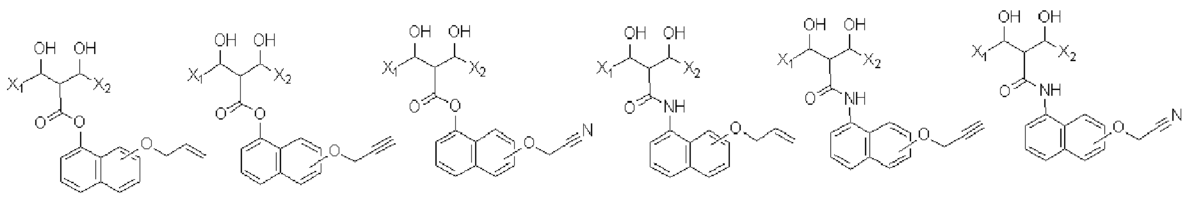

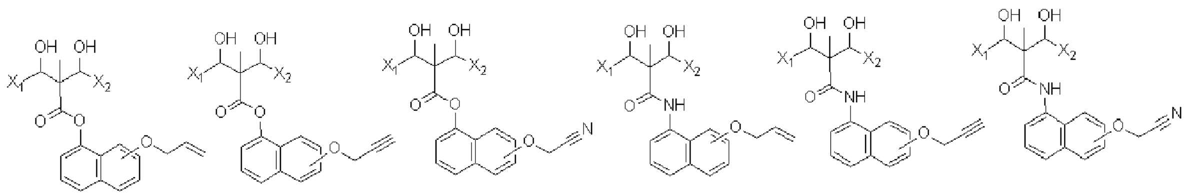

In the formulae, $X_1$ and $X_2$ each represent a hydrocarbon group having 1 to 20 carbon atoms or an alkoxy group having 1 to 20 carbon atoms.

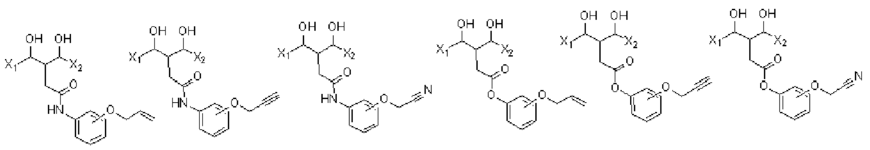

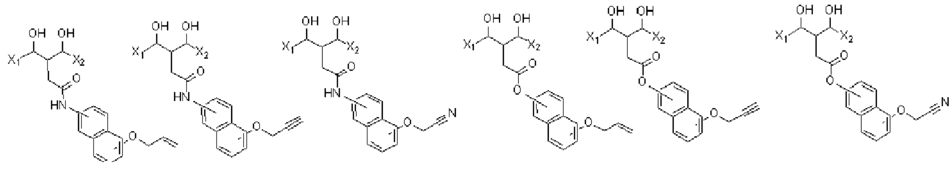

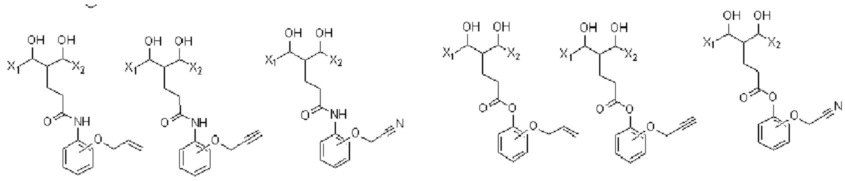

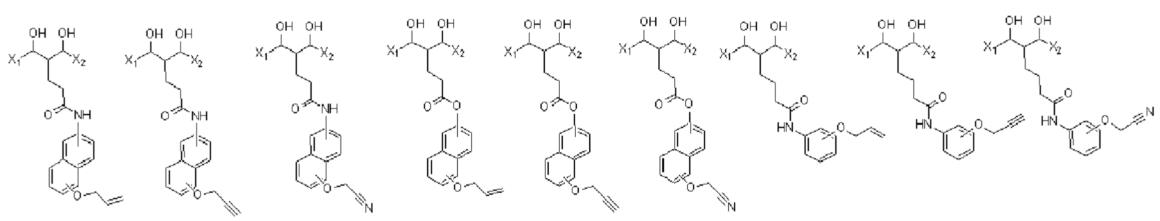

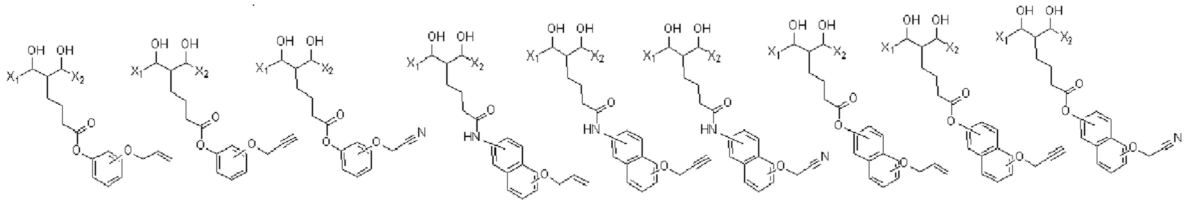

In the formulae, $X_1$ and $X_2$ each represent a hydrocarbon group having 1 to 20 carbon atoms or an alkoxy group having 1 to 20 carbon atoms.

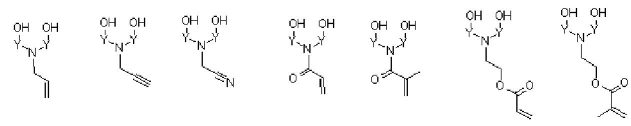

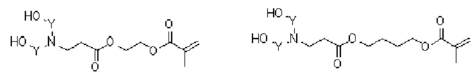

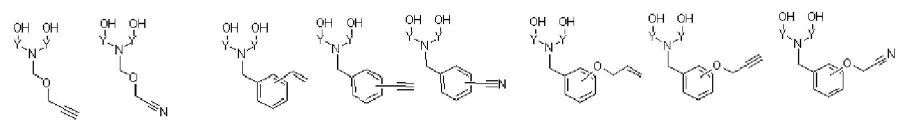

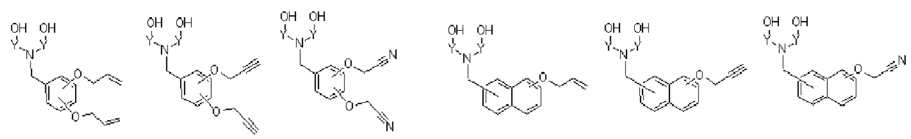

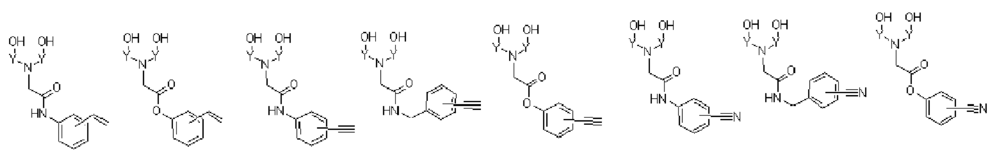

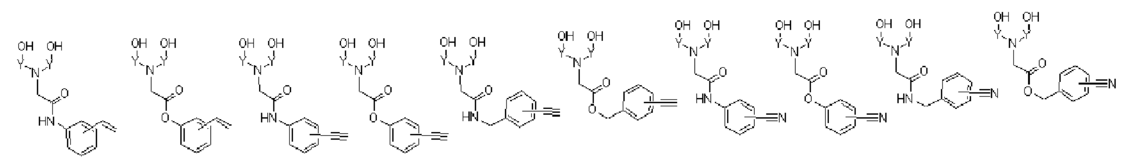

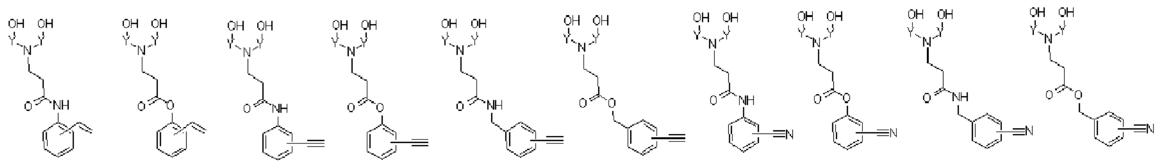

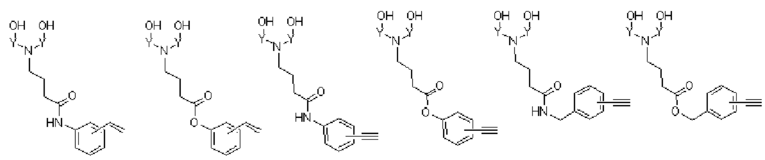

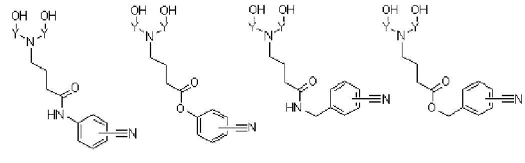

In the formulae, Y represents a divalent organic group having 1 to 10 carbon atoms.

Specific examples of ligands containing a crosslinking group represented by the general formulae (b-1) to (b-4) include the following compounds, but are not limited thereto.

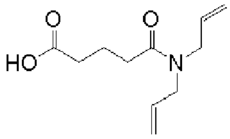 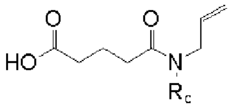 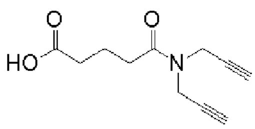 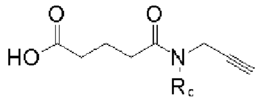

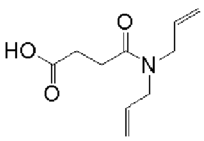 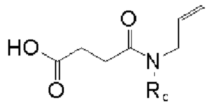 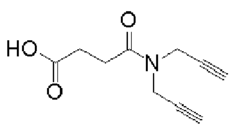 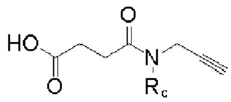

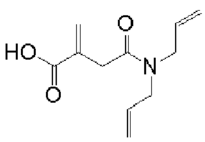 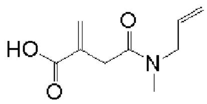 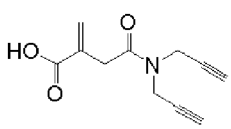 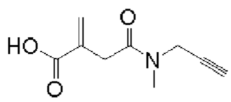

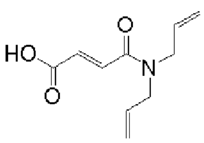 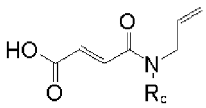 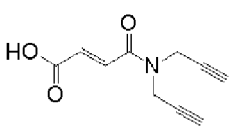 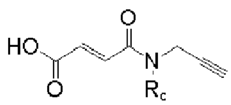

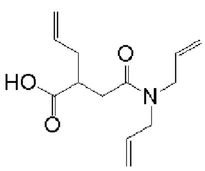 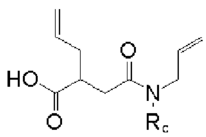 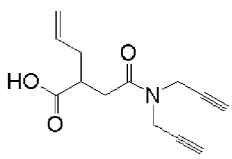 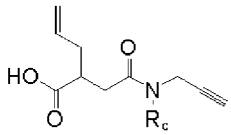

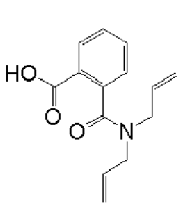 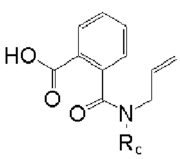 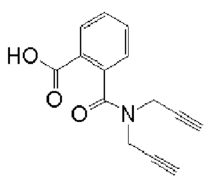 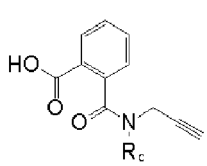

In the formulae, $R_c$ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms.

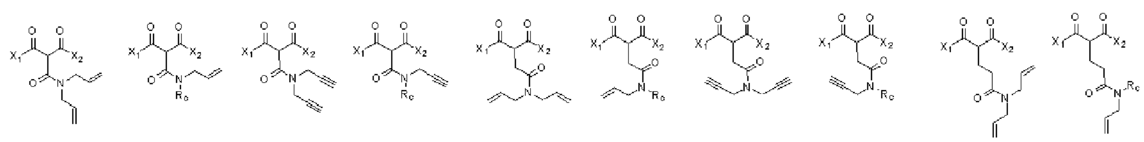

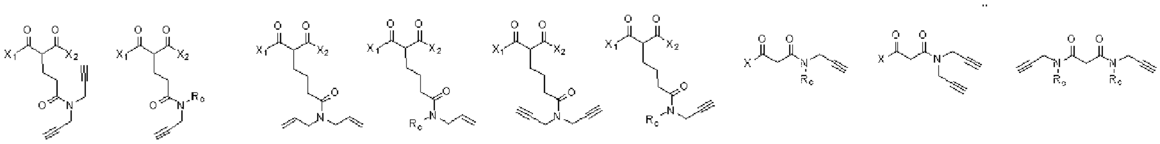

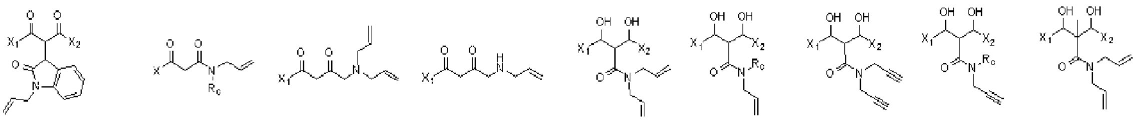

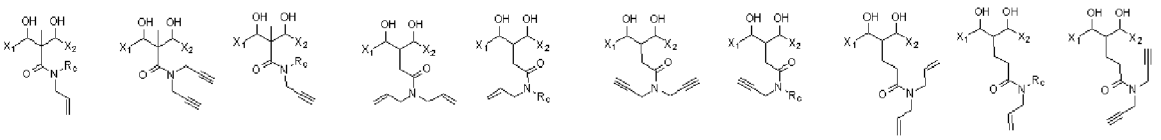

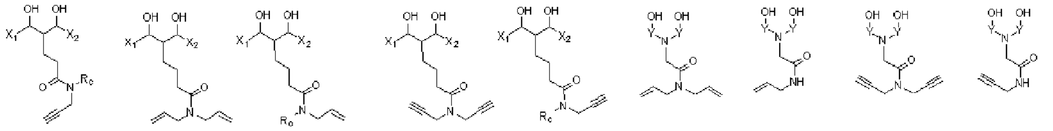

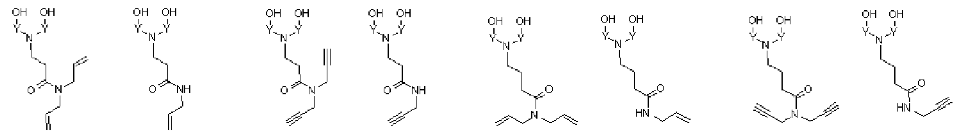

In the formulae, $R_c$ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; $X_1$ and $X_2$ each represent a hydrocarbon group having 1 to 20 carbon atoms or an alkoxy group having 1 to 20 carbon atoms; and Y represents a divalent organic group having 1 to 10 carbon atoms.

Specific examples of ligands containing a crosslinking group represented by the general formulae (c-1) to (c-3) include the following compounds, but are not limited thereto.

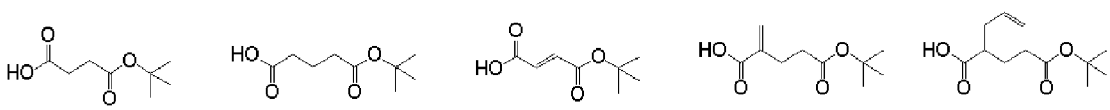

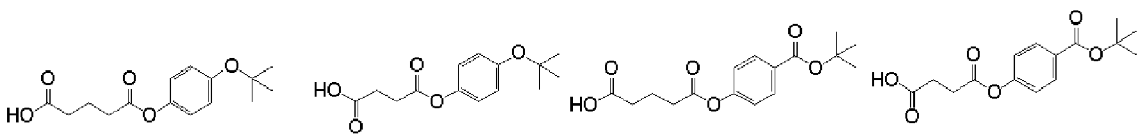

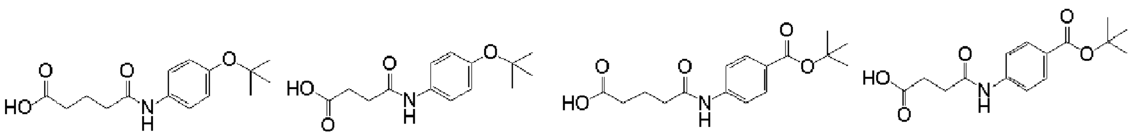

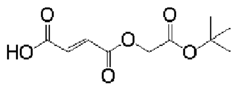
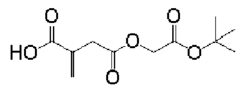
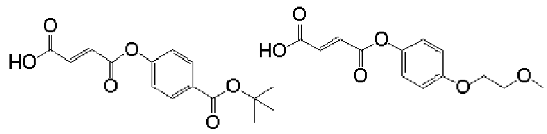

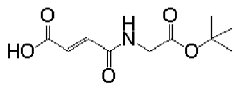
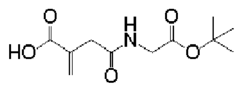
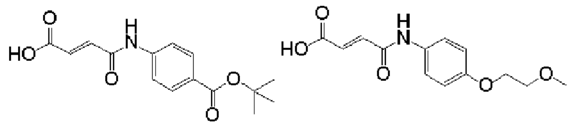

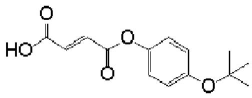
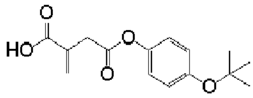
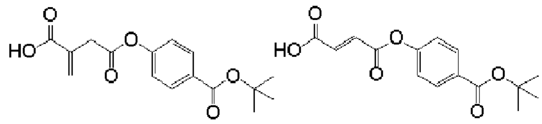

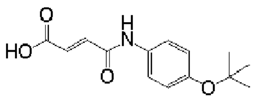
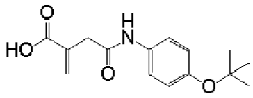
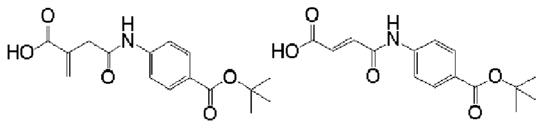

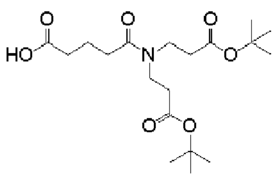
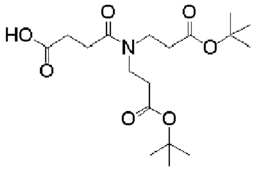
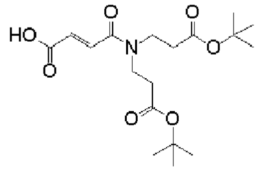
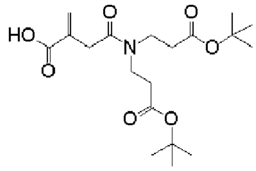

In the general formulae (c-1) to (c-3), one or more hydroxy groups or carboxy groups that are generated by the removal of a protecting group due to the action of an acid, heat, or both function as crosslinking groups.

The metal contained in the above-described metal compound is preferably titanium, zirconium, hafnium, or a combination thereof.

When the composition for forming a resist underlayer film contains a metal compound containing such a metal, the dry etching resistance at the time of substrate processing can be improved further.

As the metal compound, it is preferable to use further a compound containing a ligand derived from a silicon compound represented by the following general formula (2).

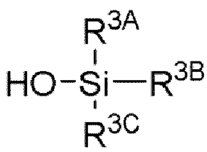
(2)

In the general formula (2), $R^{3A}$, $R^{3B}$, and $R^{3C}$ each represent any organic group selected from an organic group having 2 to 30 carbon atoms and having any crosslinking group of a structure represented by the following general formulae (d-1) to (d-3), a substituted or unsubstituted alkyl group having 1 to 20 carbon atoms, and an aryl group having 6 to 20 carbon atoms.

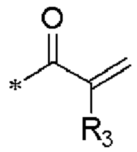
(d-1)

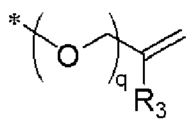
(d-2)

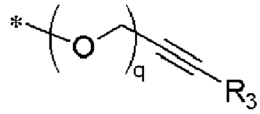
(d-3)

In the general formulae (d-1) to (d-3), $R_3$ represents a hydrogen atom or a monovalent organic group having 1 to 10 carbon atoms, "q" represents 0 or 1, and "*" represents an attachment point.

In the general formula (2), $R^{3A}$, $R^{3B}$, and $R^{3C}$ each represent any organic group selected from an organic group having 2 to 30 carbon atoms and having any crosslinking group of a structure represented by one of the general formulae (d-1) to (d-3), a substituted or unsubstituted alkyl group having 1 to 20 carbon atoms, and an aryl group having 6 to 20 carbon atoms, more preferably an organic group having 2 to 30 carbon atoms and having any crosslinking group of a structure represented by one of the general formulae (d-1) to (d-3) or an unsubstituted alkyl group having 1 to 10 carbon atoms. Among unsubstituted alkyl groups having 1 to 10 carbon atoms, a methyl group or an ethyl group is more preferable.

In the general formulae (d-1) to (d-3), each $R_3$ independently represents a hydrogen atom or a monovalent organic group having 1 to 10 carbon atoms; and each "q" independently represents 0 or 1.

When the above-described metal compound contains a ligand derived from a silicon compound represented by the general formula (2), the stability of the metal compound in the composition for forming a resist underlayer film is improved, and thus, it is possible to improve the flowability of the composition for forming a resist underlayer film.

From the viewpoint of thermosetting property, the ligand derived from a silicon compound represented by the general formula (2) more preferably has a structure represented by one of the following general formulae (2A) .

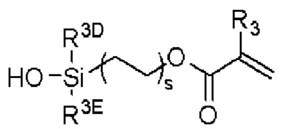
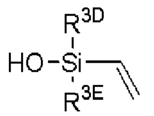
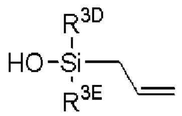
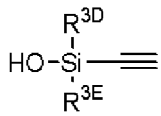
(2A)

In the general formulae (2A), $R^{3D}$ and $R^{3E}$ each represent an organic group selected from a substituted or unsubstituted alkyl group having 1 to 20 carbon atoms and an aryl group having 6 to 20 carbon atoms; $R_3$ is as defined above; and "s" represents 1 to 10.

In the general formulae (2A), $R^{3D}$ and $R^{3E}$ are more preferably a methyl group from the viewpoint of the availability of raw materials.

When a crosslinking group is contained in the ligand derived from the silicon compound as well as in the ligand containing the crosslinking group represented by the general formulae (a-1) to (a-4), (b-1) to (b-4), and (c-1) to (c-3) in the metal compound, the thermosetting property of the composition for forming a resist underlayer film can be enhanced further. When such a compound is used in a composition for forming a resist underlayer film, it is possible to form a resist underlayer film having excellent filling and planarizing properties.

In the metal compound, the metal atom may be modified with a plurality of ligands having different structures or a ligand derived from a silicon compound as long as one or more ligands containing a crosslinking group represented by the general formulae (a-1) to (a-4), (b-1) to (b-4), and (c-1) to (c-3) are included, and the ligands can be adjusted appropriately depending on the required properties. The metal compound may also have a ligand other than the ligand containing a crosslinking group represented by the general formulae (a-1) to (a-4), (b-1) to (b-4), and (c-1) to (c-3) and the ligand derived from a silicon compound. For example, the compound may include a ligand derived from an alkyl group having 1 to 10 carbon atoms.

In the metal compound, the ligand containing a crosslinking group represented by the general formulae (a-1) to (a-4), (b-1) to (b-4), and (c-1) to (c-3) is preferably contained in an amount of 10 mol% to 100 mol%, more preferably 20 mol% to 80 mol% of the total amount of ligands coordinated to the metal atom. The ligand derived from a silicon compound is preferably contained in an amount of 0 mol% to 90 mol%, more preferably 20 mol% to 80 mol% of the total amount of ligands coordinated to the metal atom. The ligand other than the ligand containing a crosslinking group represented by the general formulae (a-1) to (a-4), (b-1) to (b-4), and (c-1) to (c-3) and the ligand derived from a silicon compound, for example, a ligand derived from an alkyl group having 1 to 10 carbon atoms, is preferably contained in an amount of 0 mol% to 50 mol%, more preferably 0 mol% to 20 mol% of the total amount of the ligands coordinated to the metal atom.

In the following, the components contained in the composition for forming a resist underlayer film to be used

in the inventive method for forming a resist underlayer film other than the metal compound (A) will be described.

<(B) Organic Solvent>

The organic solvent (B) usable in the composition for forming a resist underlayer film used in the inventive method for forming a resist underlayer film is not particularly limited as long as the solvent can dissolve or disperse the metal compound (A) and, when contained, (C) a crosslinking agent, (E) a surfactant, (F) an acid generator, other additives, etc. described below.

Specifically, an organic solvent disclosed in paragraphs [0091] and [0092] in JP2007-199653A may be contained. More specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts by mass, more preferably 250 to 5,000 parts by mass relative to 100 parts by mass of the metal compound (A).

It is sufficient for the composition for forming a resist underlayer film to contain at least one kind of the above-described metal compound (A) and an organic solvent (B), and if necessary, the composition may also contain (C) a crosslinking agent, (E) a surfactant, and (F) an acid generator.

In the following, the components contained in the composition for forming a resist underlayer film used in the inventive method for forming a resist underlayer film other than the metal compound (A) will be described.

<(B1) High-Boiling-Point Solvent>

In the composition for forming a resist underlayer film used in the inventive method for forming a resist underlayer film, the organic solvent (B) may be a mixture of one or more kinds of organic solvent having a boiling point of lower than 180°C and one or more kinds of organic solvent having a boiling point of 180°C or higher ((B1) a high-boiling-point solvent).

The high-boiling-point solvent (B1) is not particularly limited to hydrocarbons, alcohols, ketones, esters, ethers, or chlorine-based solvents as long as the solvent is capable of dissolving or dispersing the components of the composition for forming a resist underlayer film used in the inventive method for forming a resist underlayer film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B1) may be selected suitably from the solvents above, for example, depending on the temperature at which the composition for forming a resist underlayer film used in the inventive method for forming a resist underlayer film is heat-treated, etc. The boiling point of the high-boiling-point solvent is preferably 180°C to 300°C, further preferably 200°C to 300°C. It is considered that when the boiling point is as described, sufficient thermal flowability can be achieved at the time of film formation, since there is no risk of excessive evaporation rate at the baking (heating). Thus, it is possible to form a resist underlayer film excellent in filling and planarizing properties. Moreover, a solvent having such a boiling point does not remain in the film without evaporating even after the baking. Therefore, there is no risk of the solvent adversely affecting the physical properties, such as etching resistance, of the film.

Furthermore, when the high-boiling-point solvent (B1) is used, the contained amount is preferably 1 to 30 parts by mass per 100 parts by mass of the organic solvent having a boiling point lower than 180°C. When the contained amount is as described, sufficient thermal flowability can be imparted at the time of baking, so that the solvent does not remain in the film and cause degradation in the physical properties, such as etching resistance, of the film. Therefore, such an amount is preferable.

[(C) Crosslinking Agent]

To increase the curability of the metal compound and further inhibit intermixing with the resist upper layer film, the composition for forming a resist underlayer film used in the inventive method for forming a resist underlayer film may also contain a crosslinking agent (C). The crosslinking agent (C) is not particularly limited, and various known crosslinking agents can be widely used. Examples include melamine-based crosslinking agents, acrylate-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g. polynuclear phenol-based, such as methylol or alkoxymethyl-based crosslinking agents). The crosslinking agent (C) is preferably contained in an amount of 5 to 50 parts by mass, more preferably 10 to 40 parts by mass relative to 100 parts by mass of the metal compound (A).

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the acrylate-based crosslinking agents include dipentaerythritol hexaacrylate.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (XL-1).

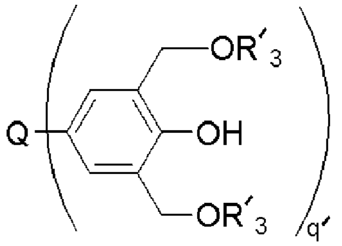
(XL-1)

In the general formula (XL-1), Q represents a single bond or a q'-valent hydrocarbon group having 1 to 20 carbon atoms. $R'_3$ represents a hydrogen atom or an alkyl group having 1 to 20 carbon atoms. "q'" represents an integer of 1 to 5.

Q represents a single bond or a hydrocarbon group having a valency of "q'" and having 1 to 20 carbon atoms. "q'" represents an integer of 1 to 5, more preferably 2 or 3. Specific examples of Q include groups obtained by removing "q'" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. $R'_3$ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl

group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (XL-1) include the following compounds. Among these, a hexamethoxymethylated derivative of triphenolmethane, triphenolethane, 1,1,1-tris(4-hydroxyphenyl)ethane, and tris(4-hydroxyphenyl)-1-ethyl-4-isopropylbenzene are preferable from the viewpoint of improving the curability and film thickness uniformity of the resist underlayer film. $R'_3$ is as defined above.

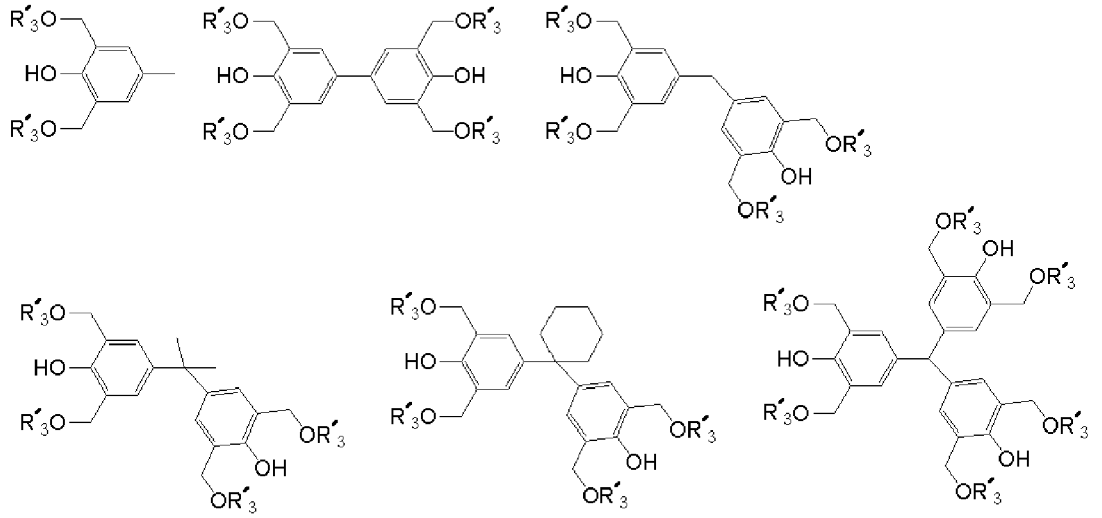

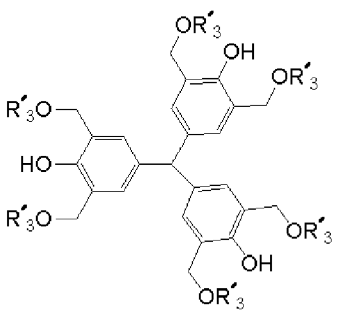

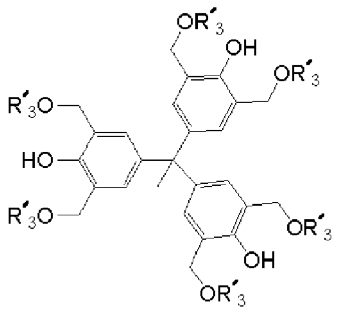

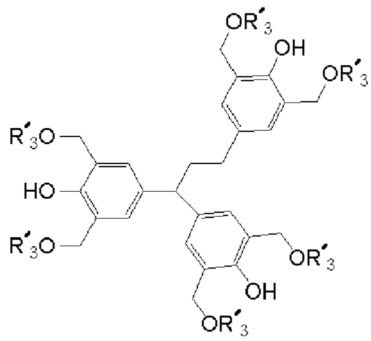

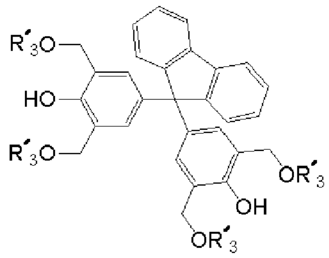

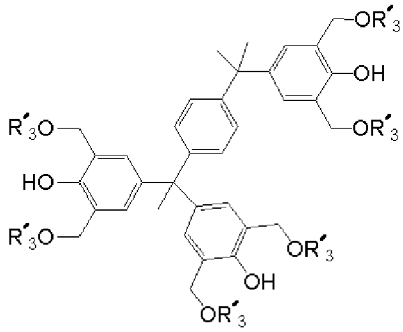

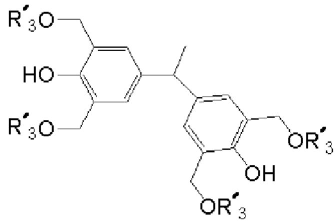

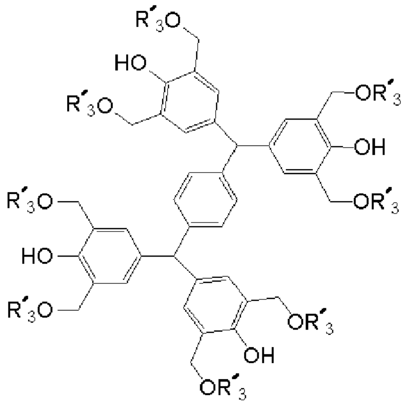

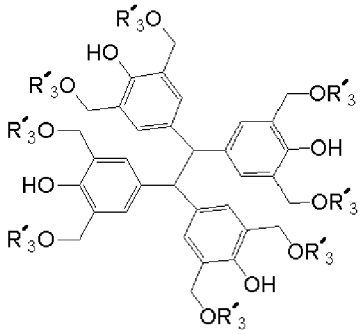

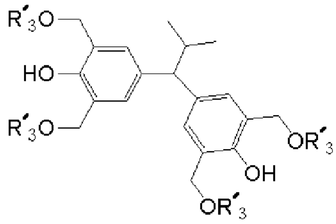

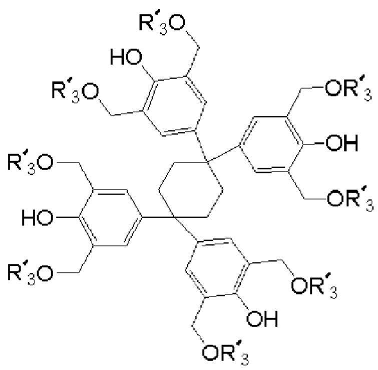

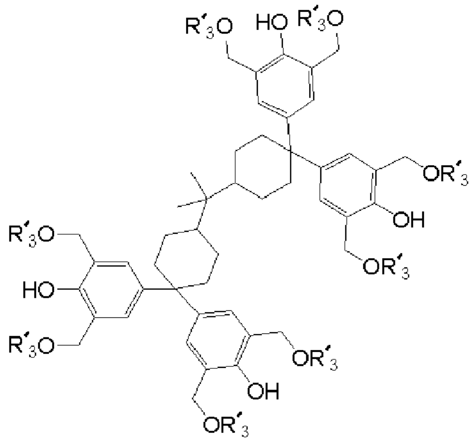

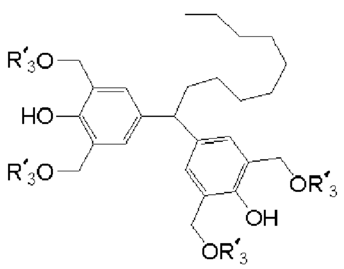

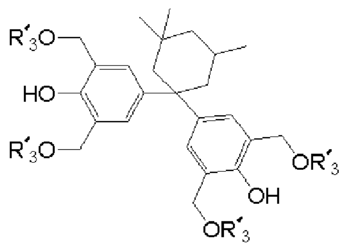

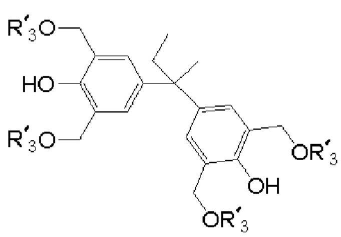

<(E) Surfactant>

A surfactant (E) may be contained in the composition for forming a resist underlayer film used in the inventive method for forming a resist underlayer film in order to improve coating property in spin-coating. Examples of the surfactant (E) include those disclosed in paragraphs [0142] to [0147] of JP2009-269953A. When the surfactant (E) is contained, the contained amount is preferably 0.01 to 10 parts by mass, more preferably 0.05 to 5 parts by mass per 100 parts by

mass of the metal compound (A).

<(F) Acid Generator>

An acid generator (F) may be contained in the composition for forming a resist underlayer film used in the inventive method for forming a resist underlayer film in order to promote the curing reaction of the metal compound (A) further. The acid generator (F) can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator (F) can be used, or two or more kinds can be used in combination. When an acid generator (F) is contained, the contained amount is preferably 0.05 to 50 parts by mass, more preferably 0.1 to 10 parts by mass relative to 100 parts by mass of the metal compound (A).

<Other Additives>

In addition, in the composition for forming a resist underlayer film used in the inventive method for forming a resist underlayer film, it is preferable to use, as an additive for imparting filling and planarizing properties, for example, a liquid additive having a polyethylene glycol or polypropylene glycol structure, or a thermo-decomposable polymer having a mass reduction rate of 40% by mass or more on heating from 30°C to 250°C and a weight-average molecular weight of 300 to 200,000. This thermo-decomposable polymer preferably contains a repeating unit having an acetal structure represented by the following general formula (DP1) or (DP1a).

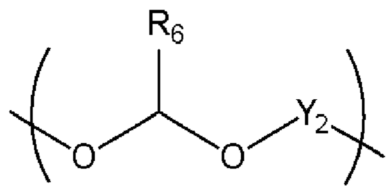

(DP1)

In the general formula (DP1), $R_6$ represents a hydrogen atom or a saturated or unsaturated monovalent organic group having 1 to 30 carbon atoms, the monovalent organic group optionally being substituted. $Y_2$ represents a saturated or unsaturated divalent organic group having 2 to 30 carbon atoms.

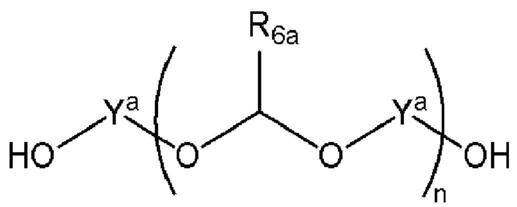

(DP1a)

In the general formula (DP1a), $R_{6a}$ represents an alkyl group having 1 to 4 carbon atoms. $Y^a$ represents a saturated or unsaturated divalent hydrocarbon group having 4 to 10 carbon atoms and optionally having an ether bond. "n" represents an average repeating unit number of 3 to 500.

<Patterning Process Using Method for Forming Resist Underlayer Film>

In addition, the present invention provides, as a patterning process according to a two-layer resist process using the above-described method for forming a resist underlayer film, a patterning process including:

forming a resist underlayer film on a substrate to be processed by using the above-described method for forming a resist underlayer film;
forming a resist upper layer film on the resist underlayer film by using a photoresist material;
subjecting the resist upper layer film to pattern exposure and then development with a developer to form a pattern in the resist upper layer film;
transferring the pattern to the resist underlayer film by dry etching while using the resist upper layer film having the formed pattern as a mask; and
processing the substrate to be processed while using the resist underlayer film having the formed pattern as a mask

to form the pattern in the substrate to be processed.

The resist upper layer film in the two-layer resist process described above exhibits etching resistance with respect to chlorine-based gas. Therefore, the dry etching of the resist underlayer film that is performed while using the resist upper layer film as a mask in the two-layer resist process is preferably performed using an etching gas mainly containing a chlorine-based gas.

The present invention also provides, as a patterning process according to a three-layer resist process using the above-described method for forming a resist underlayer film, a patterning process for forming a pattern in a substrate to be processed, including the steps of:

(I-1) forming a resist underlayer film on a substrate to be processed by the above-described method for forming a resist underlayer film;
(I-2) forming a silicon-containing resist middle layer film on the resist underlayer film;
(I-3) forming a resist upper layer film on the silicon-containing resist middle layer film by using a photoresist material;
(I-4) subjecting the resist upper layer film to pattern exposure and then development with a developer to form a pattern in the resist upper layer film;
(I-5) transferring the pattern to the silicon-containing resist middle layer film by dry etching while using the resist upper layer film having the formed pattern as a mask;
(I-6) transferring the pattern to the resist underlayer film by dry etching while using the silicon-containing resist middle layer film having the transferred pattern as a mask; and
(I-7) processing the substrate to be processed while using the resist underlayer film having the formed pattern as a mask to form the pattern in the substrate to be processed.

With reference to FIG. 1, a patterning process according to a three-layer resist process will be described. The present invention provides, as a patterning process according to a three-layer resist process using such a method for forming a resist underlayer film, the patterning process including:

forming a resist underlayer film 3 on a layer 2 to be processed on a substrate 1 to be processed by using the method for forming a resist underlayer film, forming a silicon-containing resist middle layer film 4 on the resist underlayer film by using a silicon-containing resist middle layer film material, and forming a resist upper layer film 5 on the silicon-containing resist middle layer film by using a photoresist material as in FIG. 1(A);
subsequently subjecting an exposure portion 6 of the resist upper layer film to pattern exposure as in FIG. 1(B) and then development with a developer to form a resist upper layer film pattern 5a in the resist upper layer film as in FIG. 1(C);
transferring a silicon-containing resist middle layer film pattern 4a to the silicon-containing resist middle layer film by dry etching while using the resist upper layer film having the formed pattern as a mask as in FIG. 1(D);
transferring a resist underlayer film pattern 3a to the resist underlayer film by dry etching while using the silicon-containing resist middle layer film having the transferred pattern as a mask as in FIG. 1(E); and
processing the layer to be processed on the substrate to be processed while using the resist underlayer film having the formed pattern as a mask to form a pattern 2a on the substrate 1 to be processed as in FIG. 1(F).

The silicon-containing resist middle layer film in the three-layer resist process exhibits etching resistance with respect to a chlorine-based gas. Therefore, the dry etching of the resist underlayer film that is performed while using the silicon-containing resist middle layer film as a mask in the three-layer resist process is preferably performed using an etching gas mainly containing a chlorine-based gas.

As the silicon-containing resist middle layer film in the three-layer resist process, a polysiloxane-based middle layer film is also preferably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption in such a manner that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or heat.

In addition, the present invention provides a patterning process by way of a four-layer resist process using such a method for forming a resist underlayer film, the patterning process including the steps of:

forming a resist underlayer film on a substrate to be processed by using the above-described method for forming a resist underlayer film;
forming a silicon-containing resist middle layer film on the resist underlayer film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the resist underlayer film by dry etching while using the silicon-containing resist middle layer film having the transferred pattern as a mask; and
processing the substrate to be processed while using the resist underlayer film having the formed pattern as a mask, thereby forming the pattern in the substrate to be processed.

Alternatively, an inorganic hard mask middle layer film may be formed instead of the silicon-containing resist middle layer film. In this case, a semiconductor device circuit pattern can be formed on a substrate, at least, by:

forming a resist underlayer film on a body to be processed by using the inventive method for forming a resist underlayer film;
forming an inorganic hard mask middle layer film selected from the group consisting of a silicon oxide film, a silicon nitride film, and a silicon oxynitride film on the resist underlayer film;
forming a resist upper layer film on the inorganic hard mask middle layer film by using a photoresist composition;
forming a circuit pattern in the resist upper layer film;
etching the inorganic hard mask middle layer film while using the resist upper layer film having the formed pattern as a mask;
etching the resist underlayer film while using the inorganic hard mask middle layer film having the formed pattern as a mask; and
further etching the body to be processed while using the resist underlayer film having the formed pattern as a mask to form the pattern in the body to be processed.

As described above, when the inorganic hard mask middle layer film is formed on the resist underlayer film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask middle layer film is preferably 5 to 200 nm, more preferably 10 to 100 nm. The SiON film, which has a high function as an antireflective film, is the most favorably used as the inorganic hard mask middle layer film. Since the substrate temperature increases to 300 to 500°C when the SiON film is formed, the resist underlayer film needs to withstand a temperature of 300 to 500°C. The composition for forming a resist underlayer film used in the present invention has high heat resistance and can withstand a high temperature of 300 to 500°C. Thus, the resist underlayer film formed by spin-coating and the inorganic hard mask middle layer film formed by the CVD method or the ALD method can be combined.

A photoresist film may be formed on the inorganic hard mask middle layer film as the resist upper layer film as described above. Alternatively, an organic antireflective film (BARC) or an adhesive film may be formed on the inorganic hard mask middle layer film by spin-coating, and a photoresist film may be formed thereon. In particular, when a SiON film is used as the inorganic hard mask middle layer film, the reflection can be suppressed by the two antireflective films, i.e., the SiON film and the BARC film, even in liquid immersion exposure at a high NA exceeding 1.0. Another merit of forming BARC resides in that it has an effect of reducing a footing profile of a photoresist pattern immediately above the SiON film.

The present invention also provides a patterning process for forming a pattern in a substrate to be processed, including the steps of:

(II-1) forming a resist underlayer film on a substrate to be processed by the above-described method for forming a resist underlayer film;
(II-2) forming an inorganic hard mask middle layer film selected from the group consisting of a silicon oxide film, a silicon nitride film, and a silicon oxynitride film on the resist underlayer film;
(II-3) forming an organic thin film on the inorganic hard mask middle layer film;
(II-4) forming a resist upper layer film on the organic thin film by using a photoresist material;
(II-5) subjecting the resist upper layer film to pattern exposure and then development with a developer to form a

pattern in the resist upper layer film;
(II-6) transferring the pattern to the organic thin film and the inorganic hard mask middle layer film by dry etching while using the resist upper layer film having the formed pattern as a mask;
(II-7) transferring the pattern to the resist underlayer film by dry etching while using the inorganic hard mask middle layer film having the transferred pattern as a mask; and
(II-8) processing the substrate to be processed while using the resist underlayer film having the formed pattern as a mask to form the pattern in the substrate to be processed.

In the above-described patterning process, the resist upper layer film may be either a positive type or a negative type, and it is possible to use a film similar to the typically used photoresist composition. The photoresist composition may also contain a metal atom such as Sn, In, Ga, Ge, Al, Ce, La, Cs, Zr, Hf, Ti, Bi, Sb, and Zn. In a case where the resist upper layer film is formed with the photoresist composition, a spin-coating method may be employed, or the film may be formed by a deposition treatment by a CVD method or an ALD method.

In a case where the resist upper layer film is formed by a spin-coating method, prebaking is conducted after applying the photoresist composition. The prebaking is preferably performed at 60 to 180°C for 10 to 300 seconds. Thereafter, exposure is conducted according to a usual manner, followed by post-exposure baking (PEB) and development, thereby obtaining a resist upper layer film pattern. Although the thickness of the resist upper layer film is not particularly limited, the thickness is preferably 10 to 500 nm, particularly preferably 20 to 400 nm.

In a case where the resist upper layer film is to be formed by a deposition treatment according to a CVD method or an ALD method, the photoresist composition is a metal oxide-containing film having photosensitivity to EUV, and the metal is selected from Sn, Zr, Hf, Ti, Bi, Sb, etc. In particular, Sn, which has excellent photosensitivity to EUV, is preferable. The metal oxide-containing film may be a photosensitive organometallic oxide film such as an organotin oxide (for example, haloalkyl Sn, alkoxyalkyl Sn, or amidoalkyl Sn). Some specific examples of suitable precursors include trimethyl tin chloride, dimethyltin dichloride, methyltin trichloride, tris(dimethylamino)methyl tin(IV), and (dimethylamino)trimethyl tin(IV).

The metal oxide-containing film may be deposited by PECVD or PEALD, for example, by using a Lam Vector (registered trademark) tool, separating the Sn oxide precursor from O precursor/plasma in the ALD implementation. Deposition temperature is preferably 50°C to 600°C. Deposition pressure is preferably between 100 and 6,000 mTorr. Precursor liquid flow rates for metal oxide-containing film (e.g., an organotin oxide precursor) can be 0.01 to 10 cmm, and gas flow rates ($CO_2$, CO, Ar, and $N_2$) can be 100 to 10,000 sccm. Plasma powers can be 200 to 1,000 W per 300 mm wafer station, using a high-frequency plasma (e.g., 13.56 MHz, 27.1 MHz, or higher). Deposited thickness is preferably 100 to 2,000 Å.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist upper layer film pattern as a mask. The etching of a silicon-containing resist middle layer film or an inorganic hard mask middle layer film in the three-layer resist process is performed while using the resist upper layer film pattern as a mask by using a fluorocarbon-based gas. In this manner, a silicon-containing resist middle layer film pattern or an inorganic hard mask middle layer film pattern is formed.

Next, the resist underlayer film is etched while using the obtained silicon-containing resist middle layer film pattern or inorganic hard mask middle layer film pattern as a mask. The etching of the resist underlayer film is preferably performed using an etching gas mainly containing a chlorine-based gas.

The subsequent etching of a body to be processed may also be performed according to a usual manner. For example, in the case of a body to be processed made of $SiO_2$, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The resist underlayer film obtained by the inventive method for forming a resist underlayer film is characterized by its excellent etching resistance at the time of etching of the body to be processed.

Examples of the body to be processed (substrate to be processed) include, but are not particularly limited to, substrates made of Si, $\alpha$-Si, p-Si, $SiO_2$, SiN, SiON, W, TiN, Al, etc., those in which the layers to be processed are formed on the substrate, and the like. Examples of the layers to be processed include various low-k films such as those made of Si, $SiO_2$, SiON, SiN, p-Si, $\alpha$-Si, W, W-Si, Al, Cu, Al-Si, and the like, and stopper films therefor, which can each be typically formed into a thickness of 50 to 10,000 nm, particularly 100 to 5,000 nm. When the layer to be processed is

formed, the substrate and the layer to be processed are made of different materials.

In the patterning process using the inventive method for forming a resist underlayer film, it is preferable to use a substrate to be processed having a structure or step having a height of 30 nm or more. As described above, the composition for forming a resist underlayer film used in the inventive method for forming a resist underlayer film has excellent filling and planarizing properties, so that a flat resist underlayer film can be formed even when the substrate to be processed has a step (irregularities) or structure having a height of 30 nm or more. The height of the structure or step of the substrate to be processed is preferably 30 nm or more, more preferably 50 nm or more, and further preferably 100 nm or more. In the method of processing a stepped substrate having a pattern of the above-described height, filling and planarizing by forming a film of the composition for forming a resist underlayer film used in the inventive method for forming a resist underlayer film makes it possible to achieve a uniform film thickness in the subsequently formed silicon-containing resist middle layer film and resist upper layer film. Therefore, it is easy to ensure the exposure depth margin (DOF) at the time of photolithography, which is very desirable.

Furthermore, the present invention provides a patterning process by way of a four-layer resist process using such a method for forming a resist underlayer film, the patterning process including the steps of:

forming a resist underlayer film on a substrate to be processed by using the above-described method for forming a resist underlayer film;
forming an organic middle layer film on the resist underlayer film by using an organic middle layer film material;
forming a silicon-containing resist middle layer film on the organic middle layer film by using a silicon-containing resist middle layer film material;
if necessary, forming an organic antireflective film (BARC) or an adhesive film on the silicon-containing resist middle layer film;
forming a resist upper layer film on the silicon-containing resist middle layer film, on the BARC, or on the adhesive film by using a photoresist material;
subjecting the resist upper layer film to pattern exposure and then development with a developer, thereby forming a pattern in the resist upper layer film;
transferring the pattern to the BARC or to the adhesive film and the silicon-containing resist middle layer film by dry etching while using the resist upper layer film having the formed pattern as a mask;
transferring the pattern to the organic middle layer film by dry etching while using the silicon-containing resist middle layer film having the transferred pattern as a mask;
transferring the pattern to the resist underlayer film while using the organic middle layer film having the transferred pattern as a mask; and
processing the substrate to be processed while using the resist underlayer film having the formed pattern as a mask, thereby forming the pattern in the substrate to be processed.

Furthermore, the present invention provides, as a patterning process by way of a four-layer resist process using such a method for forming a resist underlayer film, a patterning process for forming a pattern in a substrate to be processed, including the steps of:

(III-1) forming a resist underlayer film on a substrate to be processed by the above-described method for forming a resist underlayer film;
(III-2) forming an organic middle layer film on the resist underlayer film;
(III-3) forming a silicon-containing resist middle layer film or a combination of an inorganic hard mask middle layer film selected from the group consisting of a silicon oxide film, a silicon nitride film, and a silicon oxynitride film and an organic thin film on the organic middle layer film;
(III-4) forming a resist upper layer film on the silicon-containing resist middle layer film or the organic thin film by using a photoresist material;
(III-5) subjecting the resist upper layer film to pattern exposure and then development with a developer to form a pattern in the resist upper layer film;
(III-6) transferring the pattern to the silicon-containing resist middle layer film or the organic thin film and the inorganic hard mask middle layer film by dry etching while using the resist upper layer film having the formed pattern as a mask;
(III-7) transferring the pattern to the organic middle layer film by dry etching while using the silicon-containing resist middle layer film or the inorganic hard mask middle layer film having the transferred pattern as a mask;
(III-8) transferring the pattern to the resist underlayer film by dry etching while using the organic middle layer film having the transferred pattern as a mask; and
(III-9) processing the substrate to be processed while using the resist underlayer film having the formed pattern as a mask to form the pattern in the substrate to be processed.

As an organic middle layer film material that can be used for the organic middle layer film, it is possible to use: materials already known as materials for three-layer resist methods or materials for an underlayer film containing a silicon resist composition for two-layer resist methods; materials known as resist underlayer film materials for two-layer resist methods and three-layer resist methods, the materials including various resins, such as a 4,4'-(9-fluorenylidene)bisphenol novolak resin (molecular weight: 11,000) disclosed in JP2005-128509A, and also other novolak resins; etc. Furthermore, if it is desired for the resin to have a higher heat resistance than ordinary novolaks, a polycyclic skeleton can be introduced, as in a 6,6'-(9-fluorenylidene)-di(2-naphthol) novolak resin, and furthermore, a polyimide-based resin can also be selected (e.g. JP2004-153125A).

The organic middle layer film can be formed on the substrate to be processed by using a composition solution and by a spin-coating method or the like in the same manner as the photoresist composition. After forming the organic middle layer film by a spin-coating method or the like, it is desirable to bake the substrate in order to evaporate the organic solvent. The baking temperature is preferably 80 to 400°C, and the baking time is preferably 10 to 300 seconds.

Instead of the organic middle layer film, it is also possible to adopt an organic hard mask formed by a CVD method or an ALD method.

The organic middle layer film in the multilayer resist process described above exhibits etching resistance with respect to chlorine-based gas. Therefore, the dry etching of the resist underlayer film that is performed while using the organic middle layer film as a mask in the multilayer resist process is preferably performed using an etching gas mainly containing a chlorine-based gas.

EXAMPLE

The present invention is more specifically described below with reference to Synthesis Examples, Comparative Synthesis Examples, Examples, and Comparative Examples. However, the present invention is not limited to these Examples.

[Synthesis Example]

In the following Synthesis Examples, the following organic group starting material group G ((G1) to (G20)) and silicon-containing organic group starting material group H ((H1) to (H5)) were used.

The organic group starting material group G ((G1) to (G20)) is shown below.

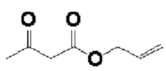
(G1)

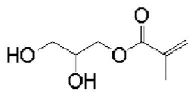
(G2)

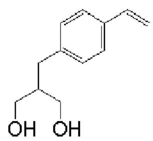
(G3)

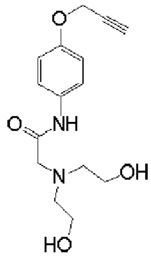
(G4)

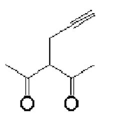
(G5)

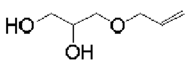
(G6)

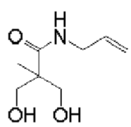
(G7)

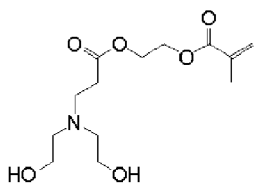
(G8)

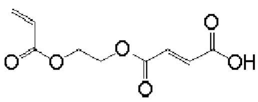
(G9)

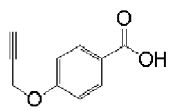
(G10)

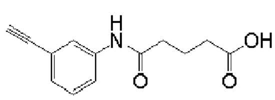
(G11)

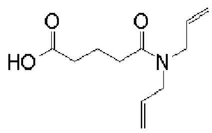
(G12)

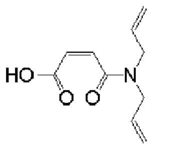
(G13)

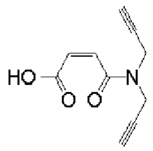
(G14)

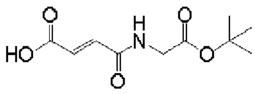
(G15)

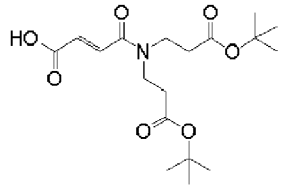
(G16)

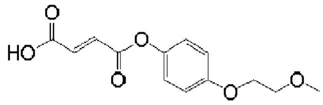
(G17)

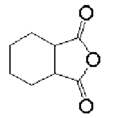
(G18)

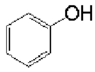
(G19)

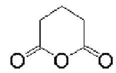
(G20)

The silicon-containing organic group starting material group H ((H1) to (H5)) is shown below.

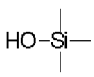
(H1)

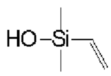
(H2)

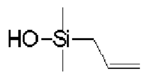
(H3)

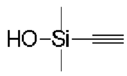
(H4)

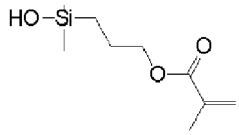
(H5)

As a metal starting material M, the following metal compounds were used.

(M1): titanium tetraisopropoxide (377996 manufactured by Sigma-Aldrich Corp)
(M2): titanium butoxide tetramer (FUJIFILM Wako Pure Chemical Corporation)
(M3): $Zr(OBu)_4$: zirconium(IV)tetrabutoxide (80 mass% solution in 1-butanol) (Z0016 manufactured by Tokyo Chemical Industry Co., Ltd.)
(M4): $Hf(OBu)_4$: hafnium(IV)n-butoxide (667943 manufactured by Sigma-Aldrich Corp)
(M5): $Ti(OBu)_4$: tetrabutyl orthotitanate (B0742 manufactured by Tokyo Chemical Industry Co., Ltd.)
(M6): titanium(IV)diisopropoxybis(2,4-pentanedionate) (75 mass% solution in isopropyl alcohol) (B3395 manufactured by Tokyo Chemical Industry Co., Ltd.)

[Synthesis Example 1] Synthesis of Compound (A-1) for Forming Resist Underlayer Film

Under a nitrogen atmosphere, an IPA solution (24.2 g) of deionized water (1.6 g) was agitated with an IPA solution (12.1 g) of a titanium tetraisopropoxide (M1) (33.4 g) and dropped at room temperature for 2 hours. The organic group starting material group (G1) (16.6 g) was added to a solution obtained and agitated at room temperature for 30 minutes. After the solution was concentrated under reduced pressure at 30°C, it was heated to 60°C and heating was continued under reduced pressure to generate no distillate. Then, a PGMEA/PGME (ratio by mass: 70/30) solution (69.0 g) was added thereto and heated under reduced pressure at 40°C until no IPA was distilled to obtain a PGMEA/PGME solution of a compound (A-1) for forming a resist underlayer film. The concentration of the components in the solution other than the solvent was 20 mass%.

[Synthesis Examples 2 to 4] Synthesis of Compounds (A-2) to (A-4) for Forming Resist Underlayer Film

The compounds (A-2) to (A-4) for forming a resist underlayer film shown in Table 1 were obtained under the same reaction conditions as in Synthesis Example 1, except that the metal starting material M and the organic group starting material group G were used at the charging amounts shown in Table 1.

[Table 1]

| Synthesis Example | Metal starting material M | | Organic group starting material group G | | Compound for forming resist underlayer film |
|---|---|---|---|---|---|
| | Starting material | g | Starting material | g | |
| 1 | M1 | 33.4 | G1 | 16.6 | A-1 |
| 2 | M2 | 28.5 | G2 | 18.8 | A-2 |
| 3 | M3 | 56.3 | G3 | 22.6 | A-3 |
| 4 | M4 | 27.6 | G4 | 17.2 | A-4 |

[Synthesis Example 5] Synthesis of Compound (A-5) for Forming Resist Underlayer Film

Under a nitrogen atmosphere, 11.8 g of tetrabutyl orthotitanate (M5) was dissolved in 20.6 g of a PGMEA/PGME (ratio by mass: 70/30) solution. The reaction temperature was raised to 50°C while stirring, and 6.5 g of the silicon-containing organic group starting material group (H1) was added dropwise to the solution. After the addition, stirring was continued for 2 hours at a reaction temperature of 60°C. Subsequently, a mixture obtained by suspending 4.8 g of the organic group starting material group (G5) in 8.6 g of a PGMEA/PGME (ratio by mass: 70/30) solution was added to the reaction system, and stirring was continued for 1 hour with the reaction temperature still at 60°C. After cooling to room temperature, the obtained reaction solution was filtered with a 0.45-μm PTFE filter. Thus, a solution of a compound (A-5) for forming a resist underlayer film in PGMEA/PGME was obtained. The concentration of the components in the solution other than the solvent was 23 mass%.

[Synthesis Examples 6 to 20] Synthesis of Compounds (A-6) to (A-20) for Forming Resist Underlayer Film

The compounds (A-6) to (A-20) for forming a resist underlayer film shown in Table 2 were obtained under the same reaction conditions as in Synthesis Example 5, except that the metal starting material M, the organic group starting material group G, and the silicon-containing organic group starting material group H were used at the charging amounts shown in Table 2.

[Table 2]

| Synthesis Example | Metal starting material M | | Organic group starting material group G | | Silicon-containing organic group starting material group H | | Compound for forming resist underlayer film |
|---|---|---|---|---|---|---|---|
| | Starting material | g | Starting material | g | Starting material | g | |
| 5 | M5 | 11.8 | G5 | 4.8 | H1 | 6.5 | A-5 |
| 6 | M5 | 16.7 | G6 | 4.6 | H2 | 6.5 | A-6 |
| 7 | M5 | 16.7 | G7 | 7.3 | H3 | 7.2 | A-7 |
| 8 | M2 | 16.7 | G8 | 7.5 | H4 | 7.2 | A-8 |
| 9 | M3 | 16.7 | G9 | 11.9 | H1 | 6.5 | A-9 |
| 10 | M4 | 16.7 | G10 | 9.8 | H2 | 7.3 | A-10 |
| 11 | M3 | 16.7 | G11 | 15.2 | H1 | 6.5 | A-11 |
| 12 | M3 | 15.0 | G12 | 11.9 | H1 | 7.2 | A-12 |
| 13 | M3 | 19.8 | G13 | 13.0 | H2 | 9.9 | A-13 |
| 14 | M3 | 10.2 | G14 | 7.9 | H4 | 6.2 | A-14 |
| 15 | M3 | 13.3 | G15 | 14.7 | H1 | 6.1 | A-15 |
| 16 | M3 | 15.3 | G16 | 13.1 | H5 | 24.0 | A-16 |
| 17 | M3 | 13.5 | G17 | 14.8 | H2 | 7.3 | A-17 |

(continued)

| Synthesis Example | Metal starting material M | | Organic group starting material group G | | Silicon-containing organic group starting material group H | | Compound for forming resist underlayer film |
|---|---|---|---|---|---|---|---|
| | Starting material | g | Starting material | g | Starting material | g | |
| 18 | M3 | 16.7 | G18 | 8.6 | H1 | 6.5 | A-18 |
| 19 | M3 | 16.7 | G19 | 6.0 | H1 | 5.9 | A-19 |
| 20 | M3 | 16.7 | G20 | 7.3 | H1 | 6.0 | A-20 |

[Synthesis of Resin (R-1) for Forming Resist Underlayer Film for Comparative Example]

Under a nitrogen atmosphere, 160.2 g of 1,5-dihydroxynaphthalene, 56.8 g of formaldehyde, and 300 g of PGME (propylene glycol monomethyl ether) were added, and homogenized at an internal temperature of 100°C. After that, a mixed solution of 8.0 g of p-toluenesulfonic acid monohydrate and 8.0 g of PGME that had been mixed and homogenized beforehand was added dropwise slowly, and a reaction was allowed to take place at an internal temperature of 80°C for 8 hours. After the reaction was completed, the resultant was cooled to room temperature, and 2,000 ml of MIBK was added thereto. The resultant was washed six times with 500 ml of pure water, and the organic layer was evaporated under reduced pressure to dryness. After adding 300 g of THF to the residue to yield a homogeneous solution, a crystal was precipitated in 2,000 g of hexane. The precipitated crystal was separated by filtration, washed twice with 500 g of hexane, and collected. The collected crystal was vacuum-dried at 70°C, thereby obtaining a resin (R-1) for forming a resist underlayer film for a Comparative Example.

The weight-average molecular weight (Mw) and the dispersity (Mw/Mn) were determined by gel permeation chromatography (GPC) using tetrahydrofuran as an eluent, and the following results were obtained.

(R-1): Mw=3,300, Mw/Mn=2.54

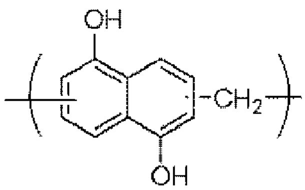

[Preparation of Composition (UDL-1) for Forming Resist Underlayer Film]

The compound (A-1) for forming a resist underlayer film was dissolved at a ratio shown in Table 3 in a mixed solvent of propylene glycol monomethyl ether acetate (PGMEA) and propylene glycol monomethyl ether (PGME) containing 0.5 mass% of a surfactant FC-4430 (manufactured by Sumitomo 3M Limited), and the solution was filtered through a 0.02-μm membrane filter to prepare a composition (UDL-1) for forming a resist underlayer film.

[Preparation of Compositions (UDL-2 to -20) for Forming Resist Underlayer Film and Composition (Comparative UDL-1) for Forming Resist Underlayer Film for Comparative Example]

Each composition was prepared in the same manner as UDL-1, except that the type and the contained amount of each compound were as shown in Table 3. In Table 3, "-" indicates that the component was not used. The following formula (F-1) was used for the acid generator (TAG) .

[Acid Generator]

The acid generator (F-1) used in the composition for forming a resist underlayer film is shown below.

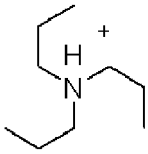 $CF_3CF_2CF_2SO_3^-$

(F-1)

[Table 3]

| Composition for forming resist underlayer film | Compound for forming resist underlayer film | Additive | Solvent |
|---|---|---|---|
| | (parts by mass) | (parts by mass) | (parts by mass) |
| UDL-1 | A-1 (10) | - | PGMEA/PGME (60/30) |
| UDL-2 | A-2 (10) | F-1 (2) | PGMEA/PGME (60/30) |
| UDL-3 | A-3 (10) | - | PGMEA/PGME (60/30) |
| UDL-4 | A-4 (10) | - | PGMEA/PGME (60/30) |
| UDL-5 | A-5 (10) | - | PGMEA/PGME (60/30) |
| UDL-6 | A-6 (10) | - | PGMEA/PGME (60/30) |
| UDL-7 | A-7 (10) | - | PGMEA/PGME (60/30) |
| UDL-8 | A-8 (10) | - | PGMEA/PGME (60/30) |
| UDL-9 | A-9 (10) | - | PGMEA/PGME (60/30) |
| UDL-10 | A-10 (10) | - | PGMEA/PGME (60/30) |
| UDL-11 | A-11 (10) | - | PGMEA/PGME (60/30) |
| UDL-12 | A-12 (10) | - | PGMEA/PGME (60/30) |
| UDL-13 | A-13 (10) | - | PGMEA/PGME (60/30) |
| UDL-14 | A-14 (10) | - | PGMEA/PGME (60/30) |
| UDL-15 | A-15 (10) | - | PGMEA/PGME (60/30) |
| UDL-16 | A-16 (10) | - | PGMEA/PGME (60/30) |
| UDL-17 | A-17 (10) | F-1 (2) | PGMEA/PGME (60/30) |

(continued)

| Composition for forming resist underlayer film | Compound for forming resist underlayer film | Additive | Solvent |
|---|---|---|---|
| | (parts by mass) | (parts by mass) | (parts by mass) |
| UDL-18 | A-18 (10) | - | PGMEA/PGME (60/30) |
| UDL-19 | A-19 (10) | - | PGMEA/PGME (60/30) |
| UDL-20 | A-20 (10) | - | PGMEA/PGME (60/30) |
| Comparative UDL-1 | R-1 (10) | - | PGMEA (90) |

[Filling Property Evaluation (Examples 1-1 to 1-17 and Comparative Example 1-1)]

Each of the compositions (UDL-1 to -17 and comparative UDL-1) prepared above was respectively applied onto an $SiO_2$ wafer substrate having a dense line-and-space pattern (line width = 60 nm, line depth = 100 nm, distance between the centers of two adjacent lines 120 nm), followed by heating by using a hot plate at 250°C for 60 seconds. Thus, a cured film having a film thickness of 80 nm was formed (filling evaluation A).

Meanwhile, separately from the above-described substrates, each of the compositions (UDL-1 to -17 and comparative UDL-1) prepared above was respectively applied onto an $SiO_2$ wafer substrate having a dense line-and-space pattern (line width = 60 nm, line depth = 100 nm, distance between the centers of two adjacent lines 120 nm), followed by heating by using a hot plate at 250°C for 60 seconds. Then, plasma irradiation was performed under the conditions given below to form a resist underlayer film (filling evaluation B).

The substrate used was a base substrate 7 ($SiO_2$ wafer substrate) having a dense line-and-space pattern shown in FIG. 2(G) (downward view) and (H) (cross-sectional view). The cross-sectional shape of each of the wafer substrates obtained in the filling evaluation A and B was observed using an electron microscope (S-4700: manufactured by Hitachi, Ltd.), and the presence/absence of voids (gaps) inside the resist underlayer film filling the space between the lines was confirmed. Table 4 shows the results. In this evaluation, when a composition for forming a resist underlayer film having a poor filling property is used, voids are generated inside the resist underlayer film filling the space between the lines. In this evaluation, when a composition for forming a resist underlayer film having a desirable filling property is used, as shown in FIG. 2(I), the inside of the resist underlayer film filling the space between the lines of the base substrate 7 having the dense line-and-space pattern is filled with a void-free resist underlayer film 8.

[Plasma Irradiation Conditions 1]

Plasma irradiation apparatus: Telius-SP manufactured by Tokyo Electron Ltd.

Pressure: 100 mT

Upper portion RF power: 200 W

Lower portion RF power: 2000 W

$H_2$ gas: 200 sccm

Upper portion HV voltage: -500 V

Time: 20 seconds

[Table 4]

| Example | Composition for forming resist underlayer film | Filling evaluation A | Filling evaluation B |
|---|---|---|---|
| | | Voids | Voids |
| Example 1-1 | UDL-1 | Absent | Absent |
| Example 1-2 | UDL-2 | Absent | Absent |
| Example 1-3 | UDL-3 | Absent | Absent |
| Example 1-4 | UDL-4 | Absent | Absent |
| Example 1-5 | UDL-5 | Absent | Absent |
| Example 1-6 | UDL-6 | Absent | Absent |
| Example 1-7 | UDL-7 | Absent | Absent |
| Example 1-8 | UDL-8 | Absent | Absent |
| Example 1-9 | UDL-9 | Absent | Absent |
| Example 1-10 | UDL-10 | Absent | Absent |
| Example 1-11 | UDL-11 | Absent | Absent |
| Example 1-12 | UDL-12 | Absent | Absent |
| Example 1-13 | UDL-13 | Absent | Absent |
| Example 1-14 | UDL-14 | Absent | Absent |
| Example 1-15 | UDL-15 | Absent | Absent |
| Example 1-16 | UDL-16 | Absent | Absent |
| Example 1-17 | UDL-17 | Absent | Absent |
| Comparative Example 1-1 | Comparative UDL-1 | Present | Present |

It was successfully confirmed that, as shown in Table 4, in Examples 1-1 to 1-17, using the inventive method for forming a resist underlayer film, it was possible to fill the dense line-and-space pattern without the generation of voids even after the plasma treatment was performed (filling evaluation B), and excellent filling property was provided.

[Etching Resistance Evaluation (Examples 2-1 to 2-20 and Comparative Example 2-1)]

Each of the compositions (UDL-1 to -20 and comparative UDL-1) for forming a resist underlayer film was respectively applied onto a silicon substrate and heated by using a hot plate at 250°C for 60 seconds to form a cured film having a film thickness of 80 nm (film thickness "a"). In addition, separately from the above evaluation, a substrate coated with the composition and heated at 250°C for 60 seconds was further subjected to a plasma treatment under the following conditions to form a resist underlayer film (film thickness "a").

[Plasma Irradiation Conditions 2]

Plasma irradiation apparatus: Telius-SP manufactured by Tokyo Electron Ltd.

Pressure: 100 mT
Upper portion RF power: 200 W
Lower portion RF power: 2000 W
$H_2$ gas: 200 sccm
Upper portion HV voltage: -500 V
Time: 20 seconds

Subsequently, etching was performed with $CF_4$ gas under the following conditions by using an etching apparatus CE-300I manufactured by ULVAC, Inc., and the film thickness "b" was measured. Then, the film thickness etched in 1

minute was calculated as an etching rate (nm/min) from the film thickness etched (film thickness "a" - film thickness "b") using each gas in a specified time. Table 5 shows the results.

Conditions of dry etching with $CF_4$ gas

Pressure: 1 Pa

Antenna RF power: 100 W

Bias RF power: 15 W

$CF_4$ gas flow rate: 15 sccm

Time: 30 sec

[Table 5]

| Example | Composition for forming resist underlayer film | Etching resistance (nm/min) | Etching resistance (nm/min) |
|---|---|---|---|
| | | Heat treatment at 250°C | Heat treatment at 250°C + plasma treatment |
| Example 2-1 | UDL-1 | 17 | 6 |
| Example 2-2 | UDL-2 | 19 | 7 |
| Example 2-3 | UDL-3 | 18 | 7 |
| Example 2-4 | UDL-4 | 19 | 8 |
| Example 2-5 | UDL-5 | 21 | 7 |
| Example 2-6 | UDL-6 | 22 | 8 |
| Example 2-7 | UDL-7 | 23 | 8 |
| Example 2-8 | UDL-8 | 27 | 10 |
| Example 2-9 | UDL-9 | 31 | 12 |
| Example 2-10 | UDL-10 | 33 | 12 |
| Example 2-11 | UDL-11 | 34 | 9 |
| Example 2-12 | UDL-12 | 35 | 12 |
| Example 2-13 | UDL-13 | 32 | 10 |
| Example 2-14 | UDL-14 | 33 | 11 |
| Example 2-15 | UDL-15 | 27 | 9 |
| Example 2-16 | UDL-16 | 26 | 8 |
| Example 2-17 | UDL-17 | 30 | 12 |
| Example 2-18 | UDL-18 | 31 | 18 |
| Example 2-19 | UDL-19 | 13 | 10 |
| Example 2-20 | UDL-20 | 16 | 12 |
| Comparative Example 2-1 | Comparative UDL-1 | 69 | 53 |

As shown in Table 5, in Examples 2-1 to 2-20, where the inventive method for forming a resist underlayer film was used, the result that etching resistance was improved compared to when only the heat treatment was performed was achieved. Also achieved was the result that the rate of improvement of the etching resistance due to the plasma treatment was higher in Examples 2-1 to 2-17, where UDL-1 to UDL-17, which are compositions for forming a resist

underlayer film containing the compounds (A-1) to (A-17) for forming a resist underlayer film containing an organic crosslinking group, were used, than in Examples 2-18 to 2-20, where UDL-18 to UDL-20, which are compositions for forming a resist underlayer film containing compounds (A-18) to (A-20) for forming a resist underlayer film containing no organic crosslinking groups, were used. The cause of this result is not certain, but there is a possibility that organic crosslinking components in the resist underlayer film are cleaved and re-crosslinked by the plasma treatment, and densification of the film occurs. Meanwhile, in Comparative Example 2-1, where comparative UDL-1, which is a composition for forming a resist underlayer film for the Comparative Example containing the resin (R-1) for forming a resist underlayer film for the Comparative Example, was used, etching resistance was found to be insufficient compared to the inventive method for forming a resist underlayer film.

[Patterning Process (Examples 3-1 to 3-17 and Comparative Example 3-1)]

Each of the compositions (UDL-1 to -17 and comparative UDL-1) for forming a resist underlayer film was respectively applied onto an $SiO_2$ wafer substrate, baked in the atmosphere at 250°C for 60 seconds, and then subjected to a plasma treatment under the following conditions to form a resist underlayer film having a thickness of 80 nm. A silicon-containing resist middle layer film material (SOG-1) was applied thereto, followed by baking at 220°C for 60 seconds to form a resist middle layer film having a thickness of 50 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

[Plasma Irradiation Conditions 3]

Plasma irradiation apparatus: Telius-SP manufactured by Tokyo Electron Ltd.

Pressure: 100 mT
Upper portion RF power: 200 W
Lower portion RF power: 2000 W
$H_2$ gas: 200 sccm
Upper portion HV voltage: -500 V
Time: 20 seconds

The silicon-containing resist middle layer film material (SOG-1) was prepared by dissolving a polymer represented by an ArF silicon-containing middle layer film polymer (SiP1) and a thermal crosslinking catalyst (CAT1) in an organic solvent containing 0.1 mass% of FC-4430 (manufactured by Sumitomo 3M Limited) in the proportion shown in Table 6; and filtering the solution through a filter made of a fluororesin and having a pore size of 0.1 μm.

[Table 6]

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4,000) |

The structural formulae of the used ArF silicon-containing middle layer film polymer (SiP1) and thermal crosslinking catalyst (CAT1) are shown below.

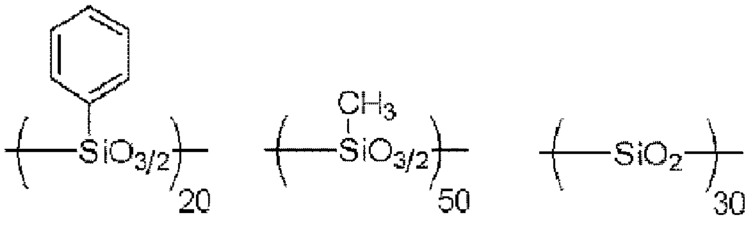

**SiP1**

Mw3,400

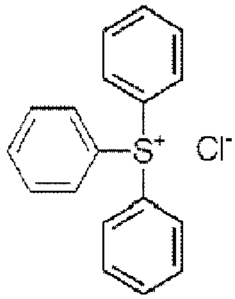

**CAT1**

The resist upper layer film material (monolayer resist for ArF) was prepared by dissolving a polymer (RP1), an acid generator (PAG1), and a basic compound (Amine1), each in the proportion shown in Table 7, in a solvent containing 0.1% by mass of a surfactant (FC-4430: manufactured by Sumitomo 3M Limited), and filtering the solution through a 0.1-pm filter made of a fluororesin.

[Table 7]

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2, 500) |

The polymer (RP1), the acid generator (PAG1), and the basic compound (Amine1) used for the resist upper layer film material (monolayer resist for ArF) are shown below.

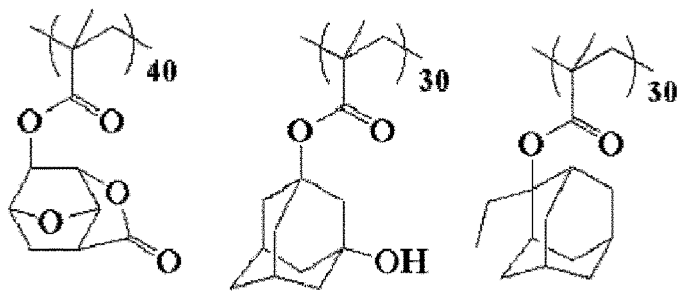

**RP1**

Mw7,800

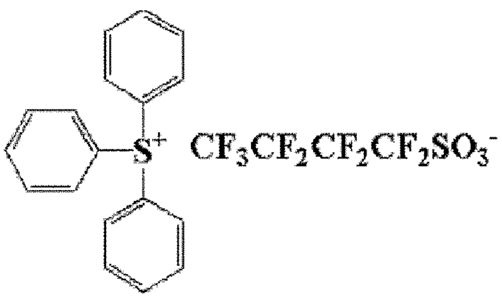

**PAG1**

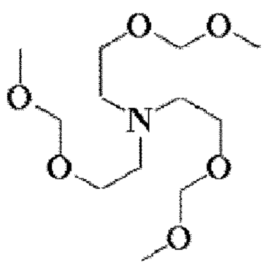

**Amine1**

The liquid immersion top coat composition (TC-1) was prepared by dissolving a top coat polymer (PP1) in an organic solvent at the proportion shown in Table 8, and filtering the solution through a 0.1-pm filter made of a fluororesin.

[Table 8]

| | Top coat polymer (parts by mass) | Organic solvent (parts by mass) |
|---|---|---|
| TC-1 | PP1 (100) | Diisoamyl ether (2,700)<br>2-methyl-1-butanol (270) |

The top coat polymer (PP1) used for the liquid immersion top coat composition (TC-1) is shown below.

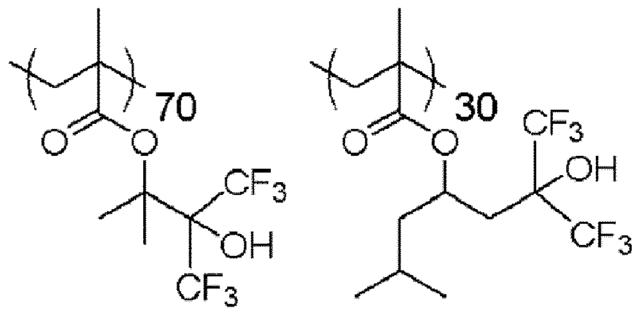

**PP1**
Mw8,800

Then, the substrate was exposed to light with an ArF liquid immersion exposure apparatus (NSR-S610C manufactured by Nikon Corporation, NA: 1.30, $\sigma$: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern).

Subsequently, the resist middle layer film was etched by dry etching while using the resist upper layer film pattern as a mask to form a hard mask pattern. The resist underlayer film was then etched while using the obtained hard mask pattern as a mask to form a resist underlayer film pattern, and the $SiO_2$ film was etched while using the obtained resist underlayer film pattern as a mask. The etching conditions were as follows.

Conditions in transferring resist upper layer film pattern to resist middle layer film

Conditions of dry etching with $CF_4$ gas

Pressure: 1 Pa
Antenna RF power: 100 W
Bias RF power: 15 W
$CF_4$ gas flow rate: 15 sccm
Time: 60 sec

Conditions in transferring hard mask pattern to resist underlayer film

Conditions of dry etching with $Cl_2$ gas

Pressure: 1 Pa
Antenna RF power: 320 W
Bias RF power: 30 W
$Cl_2$ gas flow rate: 25 sccm
Time: 45 sec

Conditions in transferring resist underlayer film pattern to $SiO_2$ film

Conditions of dry etching with $CF_4$ gas

Pressure: 1 Pa
Antenna RF power: 100 W
Bias RF power: 15 W
$CF_4$ gas flow rate: 15 sccm
Time: 60 sec

Table 9 shows the results obtained by observation of the pattern cross section with an electron microscope (S-4700) manufactured by Hitachi, Ltd.

[Table 9]

| Example | Composition for forming resist underlayer film | Patterning process |
|---|---|---|
| | | Pattern profile |
| Example 3-1 | UDL-1 | Vertical profile |
| Example 3-2 | UDL-2 | Vertical profile |
| Example 3-3 | UDL-3 | Vertical profile |
| Example 3-4 | UDL-4 | Vertical profile |
| Example 3-5 | UDL-5 | Vertical profile |
| Example 3-6 | UDL-6 | Vertical profile |
| Example 3-7 | UDL-7 | Vertical profile |
| Example 3-8 | UDL-8 | Vertical profile |
| Example 3-9 | UDL-9 | Vertical profile |
| Example 3-10 | UDL-10 | Vertical profile |
| Example 3-11 | UDL-11 | Vertical profile |
| Example 3-12 | UDL-12 | Vertical profile |
| Example 3-13 | UDL-13 | Vertical profile |
| Example 3-14 | UDL-14 | Vertical profile |
| Example 3-15 | UDL-15 | Vertical profile |
| Example 3-16 | UDL-16 | Vertical profile |
| Example 3-17 | UDL-17 | Vertical profile |
| Comparative Example 3-1 | Comparative UDL-1 | Distorted pattern |

As shown in Table 9, in the inventive patterning processes (Examples 3-1 to 3-17), the resist upper layer film pattern was successfully transferred to the substrate in the end in every case, and it was confirmed that the patterning processes can be used suitably for fine processing using a multilayer resist method. On the other hand, in Comparative Example 3-1, using comparative UDL-1 found to exhibit insufficient performance in the dry etching resistance evaluation, distortion of the pattern profile occurred at the time of pattern processing, and it was not possible to obtain a favorable pattern in the end.

From the above, the inventive methods for forming a resist underlayer film and patterning processes are particularly suitably employed in a multilayer resist process including the filling and planarization of a substrate to be processed having steps or unevenness, and are extremely useful in fine patterning for manufacturing semiconductor devices.

The present description includes the following embodiments.

[1]: A method for forming a resist underlayer film, comprising the steps of:

(i) coating a substrate with a composition for forming a resist underlayer film containing a metal compound having a metal-oxygen covalent bond and an organic solvent;
(ii) forming a cured film by heating the coated substrate at a temperature of 100°C or higher and 600°C or lower for 10 seconds to 7,200 seconds for curing; and
(iii) forming a resist underlayer film by irradiating the cured film with plasma, wherein
a compound containing at least one crosslinking group represented by the following general formulae (a-1) to (a-4), (b-1) to (b-4), and (c-1) to (c-3) is used as the metal compound,

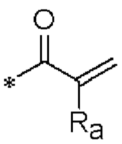
(a-1)

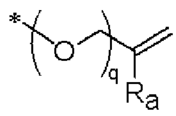
(a-2)

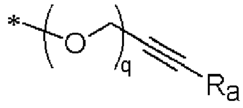
(a-3)

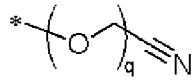
(a-4)

wherein $R_a$ represents a hydrogen atom or a monovalent organic group having 1 to 10 carbon atoms, "q" represents 0 or 1, and "*" represents an attachment point,

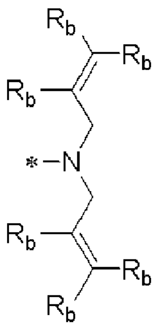
(b-1)

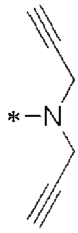
(b-2)

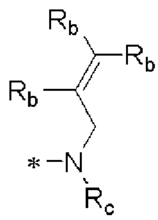
(b-3)

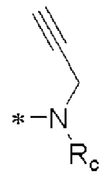
(b-4)

wherein $R_b$s represent a hydrogen atom or a methyl group and are identical to or different from each other in a single formula, $R_c$ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point,

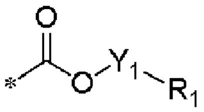
(c-1)

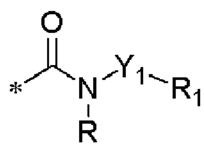
(c-2)

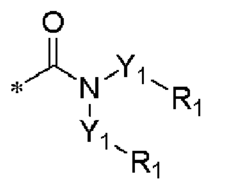
(c-3)

wherein $Y_1$ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, $R_1$ represents an organic group whose protecting group is to be removed by an action of an acid, heat, or both to generate one or more hydroxy groups or carboxy groups, $R_1$ being represented by one of the following general formulae (1), and "*" represents an attachment point,

$R_1 =$ 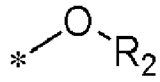 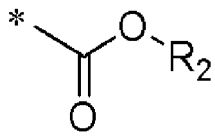 (1)

wherein $R_2$ represents an organic group whose protecting group is to be removed by an action of an acid, heat, or both, and "*" represents an attachment point to $Y_1$.

[2]: The method for forming a resist underlayer film of the above [1], wherein $N_2$, $NF_3$, $H_2$, a fluorocarbon, a rare gas, or a mixed gas thereof is used in the step (iii).
[3]: The method for forming a resist underlayer film of the above [2], wherein a gas containing $H_2$ gas is used in the step (iii).
[4]: The method for forming a resist underlayer film of the above [2] or [3], wherein a gas containing helium gas is used in the step (iii).
[5]: The method for forming a resist underlayer film of any one of the above [1] to [4], wherein the cured film is formed by heating in an atmosphere having an oxygen concentration of 1 volume % or more and 21 volume % or less in the step (ii).
[6]: The method for forming a resist underlayer film of any one of the above [1] to [4], wherein the cured film is formed by heating in an atmosphere having an oxygen concentration of less than 1 volume % in the step (ii).
[7]: The method for forming a resist underlayer film of any one of the above [1] to [6], wherein the cured film is formed by heating at a temperature of 100°C or higher and 450°C or lower for 10 seconds to 7,200 seconds for curing in the step (ii).
[8]: The method for forming a resist underlayer film of any one of the above [1] to [7], wherein the metal contained in the metal compound is titanium, zirconium, hafnium, or a combination thereof.
[9]: The method for forming a resist underlayer film of any one of the above [1] to [8], wherein a compound containing a ligand derived from a silicon compound represented by the following general formula (2) is further used as the metal compound,

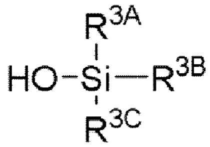 (2)

wherein $R^{3A}$, $R^{3B}$, and $R^{3C}$ each represent any organic group selected from an organic group having 2 to 30 carbon atoms and having any crosslinking group of a structure represented by the following general formulae (d-1) to (d-3), a substituted or unsubstituted alkyl group having 1 to 20 carbon atoms, and an aryl group having 6 to 20 carbon atoms,

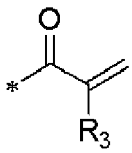
(d-1)

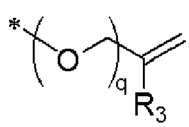
(d-2)

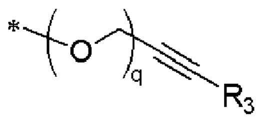
(d-3)

wherein $R_3$ represents a hydrogen atom or a monovalent organic group having 1 to 10 carbon atoms, "q" represents 0 or 1, and "*" represents an attachment point.
[10]: A patterning process for forming a pattern in a substrate to be processed, comprising the steps of:

(I-1) forming a resist underlayer film on a substrate to be processed by the method for forming a resist underlayer film of any one of the above [1] to [9] ;
(I-2) forming a silicon-containing resist middle layer film on the resist underlayer film;
(I-3) forming a resist upper layer film on the silicon-containing resist middle layer film by using a photoresist material;

(I-4) subjecting the resist upper layer film to pattern exposure and then development with a developer to form a pattern in the resist upper layer film;
(I-5) transferring the pattern to the silicon-containing resist middle layer film by dry etching while using the resist upper layer film having the formed pattern as a mask;
(I-6) transferring the pattern to the resist underlayer film by dry etching while using the silicon-containing resist middle layer film having the transferred pattern as a mask; and
(I-7) processing the substrate to be processed while using the resist underlayer film having the formed pattern as a mask to form the pattern in the substrate to be processed.

[11]: A patterning process for forming a pattern in a substrate to be processed, comprising the steps of:

(II-1) forming a resist underlayer film on a substrate to be processed by the method for forming a resist underlayer film of any one of the above [1] to [9];
(II-2) forming an inorganic hard mask middle layer film selected from the group consisting of a silicon oxide film, a silicon nitride film, and a silicon oxynitride film on the resist underlayer film;
(II-3) forming an organic thin film on the inorganic hard mask middle layer film;
(II-4) forming a resist upper layer film on the organic thin film by using a photoresist material;
(II-5) subjecting the resist upper layer film to pattern exposure and then development with a developer to form a pattern in the resist upper layer film;
(II-6) transferring the pattern to the organic thin film and the inorganic hard mask middle layer film by dry etching while using the resist upper layer film having the formed pattern as a mask;
(II-7) transferring the pattern to the resist underlayer film by dry etching while using the inorganic hard mask middle layer film having the transferred pattern as a mask; and
(II-8) processing the substrate to be processed while using the resist underlayer film having the formed pattern as a mask to form the pattern in the substrate to be processed.

[12]: A patterning process for forming a pattern in a substrate to be processed, comprising the steps of:

(III-1) forming a resist underlayer film on a substrate to be processed by the method for forming a resist underlayer film of any one of the above [1] to [9];
(III-2) forming an organic middle layer film on the resist underlayer film;
(III-3) forming a silicon-containing resist middle layer film or a combination of an inorganic hard mask middle layer film selected from the group consisting of a silicon oxide film, a silicon nitride film, and a silicon oxynitride film and an organic thin film on the organic middle layer film;
(III-4) forming a resist upper layer film on the silicon-containing resist middle layer film or the organic thin film by using a photoresist material;
(III-5) subjecting the resist upper layer film to pattern exposure and then development with a developer to form a pattern in the resist upper layer film;
(III-6) transferring the pattern to the silicon-containing resist middle layer film or the organic thin film and the inorganic hard mask middle layer film by dry etching while using the resist upper layer film having the formed pattern as a mask;
(III-7) transferring the pattern to the organic middle layer film by dry etching while using the silicon-containing resist middle layer film or the inorganic hard mask middle layer film having the transferred pattern as a mask;
(III-8) transferring the pattern to the resist underlayer film by dry etching while using the organic middle layer film having the transferred pattern as a mask; and
(III-9) processing the substrate to be processed while using the resist underlayer film having the formed pattern as a mask to form the pattern in the substrate to be processed.

[13]: A method for forming a resist underlayer film, comprising the steps of:

(i') coating a substrate with a composition for forming a resist underlayer film containing a metal belonging to the third period to the seventh period and the group III to the group XV of the periodic table;
(ii) forming a cured film by heating the coated substrate at a temperature of 100°C or higher and 600°C or lower for 10 seconds to 7,200 seconds for curing; and
(iii) forming a resist underlayer film by irradiating the cured film with plasma.

[14]: The method for forming a resist underlayer film of the above [13], wherein a composition containing a metal compound having a metal-oxygen covalent bond or containing a metal compound having a metal-carbon covalent

bond is used as the composition for forming a resist underlayer film.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

**1.** A method for forming a resist underlayer film, comprising the steps of:

(i) coating a substrate with a composition for forming a resist underlayer film containing a metal compound having a metal-oxygen covalent bond and an organic solvent;
(ii) forming a cured film by heating the coated substrate at a temperature of 100°C or higher and 600°C or lower for 10 seconds to 7,200 seconds for curing; and
(iii) forming a resist underlayer film by irradiating the cured film with plasma, wherein
a compound containing at least one crosslinking group represented by the following general formulae (a-1) to (a-4), (b-1) to (b-4), and (c-1) to (c-3) is used as the metal compound,

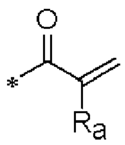
(a-1)

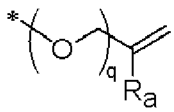
(a-2)

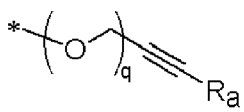
(a-3)

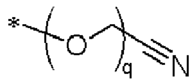
(a-4)

wherein $R_a$ represents a hydrogen atom or a monovalent organic group having 1 to 10 carbon atoms, "q" represents 0 or 1, and "*" represents an attachment point,

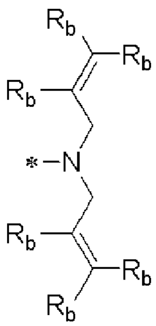
(b-1)

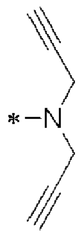
(b-2)

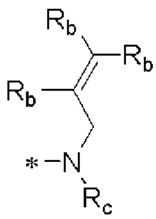
(b-3)

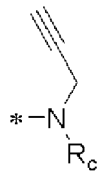
(b-4)

wherein $R_b$s represent a hydrogen atom or a methyl group and are identical to or different from each other in a single formula, $R_c$ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point,

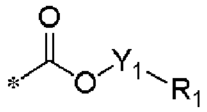

(c-1)

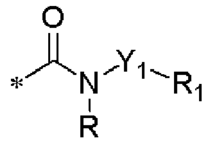

(c-2)

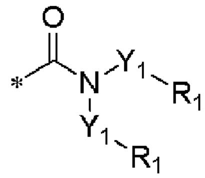

(c-3)

wherein $Y_1$ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, $R_1$ represents an organic group whose protecting group is to be removed by an action of an acid, heat, or both to generate one or more hydroxy groups or carboxy groups, $R_2$ being represented by one of the following general formulae (1), and "*" represents an attachment point,

$R_1$ =

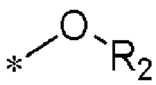

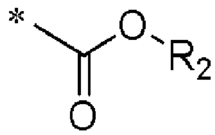

(1)

wherein $R_2$ represents an organic group whose protecting group is to be removed by an action of an acid, heat, or both, and "*" represents an attachment point to $Y_1$.

2. The method for forming a resist underlayer film according to claim 1, wherein $N_2$, $NF_3$, $H_2$, a fluorocarbon, a rare gas, or a mixed gas thereof is used in the step (iii) .

3. The method for forming a resist underlayer film according to claim 2, wherein a gas containing $H_2$ gas is used in the step (iii).

4. The method for forming a resist underlayer film according to claim 2 or 3, wherein a gas containing helium gas is used in the step (iii).

5. The method for forming a resist underlayer film according to any one of claims 1 to 4, wherein the cured film is formed by heating in an atmosphere having an oxygen concentration of 1 volume % or more and 21 volume % or less in the step (ii).

6. The method for forming a resist underlayer film according to any one of claims 1 to 4, wherein the cured film is formed by heating in an atmosphere having an oxygen concentration of less than 1 volume % in the step (ii) .

7. The method for forming a resist underlayer film according to any one of claims 1 to 6, wherein the cured film is formed by heating at a temperature of 100°C or higher and 450°C or lower for 10 seconds to 7,200 seconds for curing in the step (ii).

8. The method for forming a resist underlayer film according to any one of claims 1 to 7, wherein the metal contained in the metal compound is titanium, zirconium, hafnium, or a combination thereof.

9. The method for forming a resist underlayer film according to any one of claims 1 to 8, wherein a compound containing a ligand derived from a silicon compound represented by the following general formula (2) is further used as the metal compound,

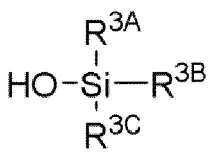

(2)

wherein $R^{3A}$, $R^{3B}$, and $R^{3C}$ each represent any organic group selected from an organic group having 2 to 30 carbon atoms and having any crosslinking group of a structure represented by the following general formulae (d-1) to (d-3), a substituted or unsubstituted alkyl group having 1 to 20 carbon atoms, and an aryl group having 6 to 20 carbon atoms,

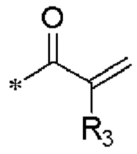

(d-1)

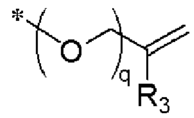

(d-2)

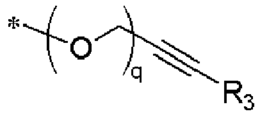

(d-3)

wherein $R_3$ represents a hydrogen atom or a monovalent organic group having 1 to 10 carbon atoms, "q" represents 0 or 1, and "*" represents an attachment point.

**10.** A patterning process for forming a pattern in a substrate to be processed, comprising the steps of:

(I-1) forming a resist underlayer film on a substrate to be processed by the method for forming a resist underlayer film according to any one of claims 1 to 9;
(I-2) forming a silicon-containing resist middle layer film on the resist underlayer film;
(I-3) forming a resist upper layer film on the silicon-containing resist middle layer film by using a photoresist material;
(I-4) subjecting the resist upper layer film to pattern exposure and then development with a developer to form a pattern in the resist upper layer film;
(I-5) transferring the pattern to the silicon-containing resist middle layer film by dry etching while using the resist upper layer film having the formed pattern as a mask;
(I-6) transferring the pattern to the resist underlayer film by dry etching while using the silicon-containing resist middle layer film having the transferred pattern as a mask; and
(I-7) processing the substrate to be processed while using the resist underlayer film having the formed pattern as a mask to form the pattern in the substrate to be processed.

**11.** A patterning process for forming a pattern in a substrate to be processed, comprising the steps of:

(II-1) forming a resist underlayer film on a substrate to be processed by the method for forming a resist underlayer film according to any one of claims 1 to 9;
(II-2) forming an inorganic hard mask middle layer film selected from the group consisting of a silicon oxide film, a silicon nitride film, and a silicon oxynitride film on the resist underlayer film;
(II-3) forming an organic thin film on the inorganic hard mask middle layer film;
(II-4) forming a resist upper layer film on the organic thin film by using a photoresist material;
(II-5) subjecting the resist upper layer film to pattern exposure and then development with a developer to form a pattern in the resist upper layer film;
(II-6) transferring the pattern to the organic thin film and the inorganic hard mask middle layer film by dry etching while using the resist upper layer film having the formed pattern as a mask;
(II-7) transferring the pattern to the resist underlayer film by dry etching while using the inorganic hard mask middle layer film having the transferred pattern as a mask; and
(II-8) processing the substrate to be processed while using the resist underlayer film having the formed pattern as a mask to form the pattern in the substrate to be processed.

**12.** A patterning process for forming a pattern in a substrate to be processed, comprising the steps of:

(III-1) forming a resist underlayer film on a substrate to be processed by the method for forming a resist underlayer film according to any one of claims 1 to 9;
(III-2) forming an organic middle layer film on the resist underlayer film;
(III-3) forming a silicon-containing resist middle layer film or a combination of an inorganic hard mask middle layer film selected from the group consisting of a silicon oxide film, a silicon nitride film, and a silicon oxynitride film and an organic thin film on the organic middle layer film;

(III-4) forming a resist upper layer film on the silicon-containing resist middle layer film or the organic thin film by using a photoresist material;
(III-5) subjecting the resist upper layer film to pattern exposure and then development with a developer to form a pattern in the resist upper layer film;
(III-6) transferring the pattern to the silicon-containing resist middle layer film or the organic thin film and the inorganic hard mask middle layer film by dry etching while using the resist upper layer film having the formed pattern as a mask;
(III-7) transferring the pattern to the organic middle layer film by dry etching while using the silicon-containing resist middle layer film or the inorganic hard mask middle layer film having the transferred pattern as a mask;
(III-8) transferring the pattern to the resist underlayer film by dry etching while using the organic middle layer film having the transferred pattern as a mask; and
(III-9) processing the substrate to be processed while using the resist underlayer film having the formed pattern as a mask to form the pattern in the substrate to be processed.

**13.** A method for forming a resist underlayer film, comprising the steps of:

(i') coating a substrate with a composition for forming a resist underlayer film containing a metal belonging to the third period to the seventh period and the group III to the group XV of the periodic table;
(ii) forming a cured film by heating the coated substrate at a temperature of 100°C or higher and 600°C or lower for 10 seconds to 7,200 seconds for curing; and
(iii) forming a resist underlayer film by irradiating the cured film with plasma.

**14.** The method for forming a resist underlayer film according to claim 13, wherein a composition containing a metal compound having a metal-oxygen covalent bond or containing a metal compound having a metal-carbon covalent bond is used as the composition for forming a resist underlayer film.

[FIG. 1]

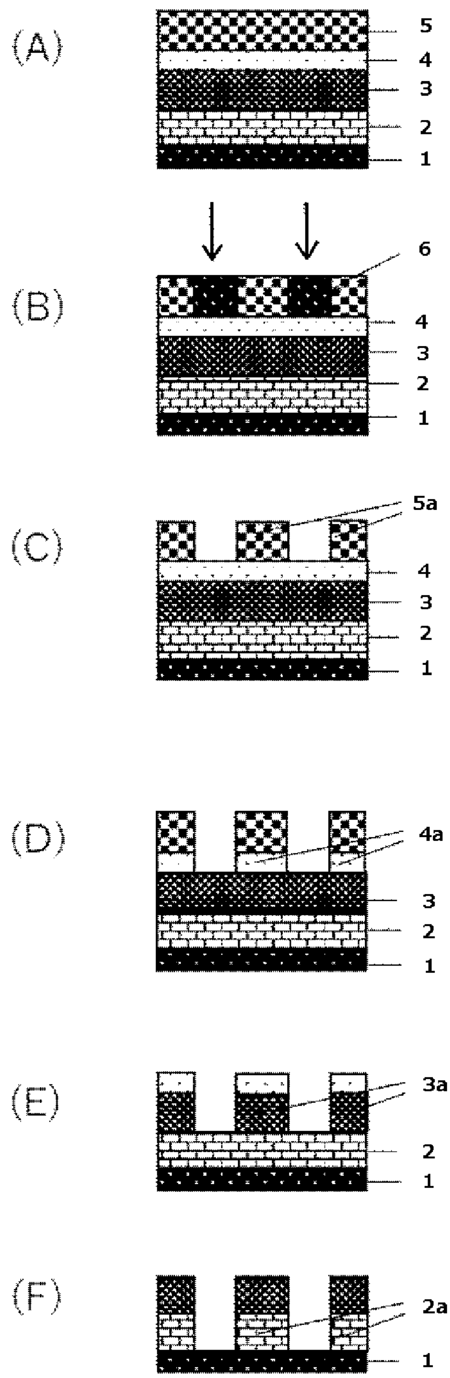

[FIG. 2]

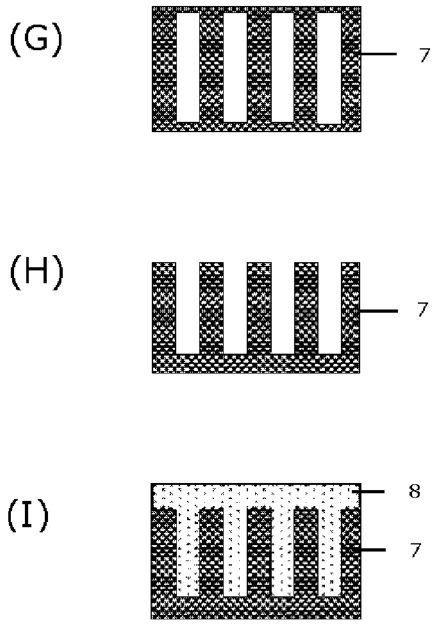

Europäisches Patentamt
European Patent Office
Office européen des brevets

# EUROPEAN SEARCH REPORT

Application Number
EP 24 16 1393

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2018/190380 A1 (NISSAN CHEMICAL CORP [JP]) 18 October 2018 (2018-10-18) * paragraphs [0005] - [0009]; claims 1-25; examples 1-4 * | 1-14 | INV. G03F7/075 G03F7/09 G03F7/11 |
| A | WO 2022/270484 A1 (JSR CORP [JP]) 29 December 2022 (2022-12-29) * experimental part; paragraphs [0066] - [0076]; claims 1-6 * | 1-14 | |
| A | US 6 759 133 B2 (DOW CORNING [US]) 6 July 2004 (2004-07-06) * column 2, lines 25-54; claims 1-36; examples 1-6 * | 1-14 | |
| A | US 2002/106500 A1 (ALBANO RALPH [US] ET AL) 8 August 2002 (2002-08-08) * paragraphs [0014] - [0016]; claims 1-46; examples 1-4 * | 1-14 | |
| A | US 2019/016906 A1 (SEOL MINSU [KR] ET AL) 17 January 2019 (2019-01-17) * experimental part; paragraphs [0002], [0007], [0028] - [0069], [0163] - [0176]; claims 1-30 * | 1-14 | TECHNICAL FIELDS SEARCHED (IPC) G03F |
| A | WO 2021/209476 A1 (MERCK PATENT GMBH [DE]) 21 October 2021 (2021-10-21) * working composition 1 to 4; paragraphs [0001], [0002], [0011] - [0024], [0121] - [0140]; claims 1-22 * | 1-14 | |
| A | US 2022/025109 A1 (RAHMAN M DALIL [US] ET AL) 27 January 2022 (2022-01-27) * the claims; the examples; paragraphs [0001], [0042] - [0100], [0212] - [0226] * | 1-14 | |

The present search report has been drawn up for all claims

1

| Place of search | Date of completion of the search | Examiner |
|---|---|---|
| Munich | 4 August 2024 | Eggers, Karin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO.

EP 24 16 1393

This annex lists the patent family members relating to the patent documents cited in the above-mentioned European search report. The members are as contained in the European Patent Office EDP file on
The European Patent Office is in no way liable for these particulars which are merely given for the purpose of information.

04-08-2024

| Patent document cited in search report | Publication date | Patent family member(s) | Publication date |
|---|---|---|---|
| WO 2018190380 A1 | 18-10-2018 | CN 110546568 A | 06-12-2019 |
| | | JP 7332982 B2 | 24-08-2023 |
| | | JP 2023109817 A | 08-08-2023 |
| | | JP WO2018190380 A1 | 20-02-2020 |
| | | KR 20190137845 A | 11-12-2019 |
| | | KR 20230148380 A | 24-10-2023 |
| | | TW 201903045 A | 16-01-2019 |
| | | US 2020124966 A1 | 23-04-2020 |
| | | WO 2018190380 A1 | 18-10-2018 |
| WO 2022270484 A1 | 29-12-2022 | JP WO2022270484 A1 | 29-12-2022 |
| | | KR 20240025531 A | 27-02-2024 |
| | | TW 202302686 A | 16-01-2023 |
| | | US 2024153768 A1 | 09-05-2024 |
| | | WO 2022270484 A1 | 29-12-2022 |
| US 6759133 B2 | 06-07-2004 | AT E299475 T1 | 15-07-2005 |
| | | AU 4590501 A | 03-10-2001 |
| | | DE 60111926 T2 | 20-04-2006 |
| | | EP 1265813 A2 | 18-12-2002 |
| | | JP 2003528021 A | 24-09-2003 |
| | | TW 524773 B | 21-03-2003 |
| | | US 6576300 B1 | 10-06-2003 |
| | | US 2003175535 A1 | 18-09-2003 |
| | | US 2003203217 A1 | 30-10-2003 |
| | | WO 0170628 A2 | 27-09-2001 |
| US 2002106500 A1 | 08-08-2002 | CN 1695235 A | 09-11-2005 |
| | | EP 1428253 A1 | 16-06-2004 |
| | | JP 2005503672 A | 03-02-2005 |
| | | KR 20040064691 A | 19-07-2004 |
| | | US 2002106500 A1 | 08-08-2002 |
| | | WO 03025993 A1 | 27-03-2003 |
| US 2019016906 A1 | 17-01-2019 | CN 109254499 A | 22-01-2019 |
| | | EP 3428722 A1 | 16-01-2019 |
| | | US 2019016906 A1 | 17-01-2019 |
| WO 2021209476 A1 | 21-10-2021 | CN 115427890 A | 02-12-2022 |
| | | EP 4136508 A1 | 22-02-2023 |
| | | JP 2023521230 A | 23-05-2023 |
| | | KR 20230007391 A | 12-01-2023 |
| | | TW 202204539 A | 01-02-2022 |
| | | US 2023236509 A1 | 27-07-2023 |
| | | WO 2021209476 A1 | 21-10-2021 |

EPO FORM P0459

For more details about this annex : see Official Journal of the European Patent Office, No. 12/82

## ANNEX TO THE EUROPEAN SEARCH REPORT ON EUROPEAN PATENT APPLICATION NO.

EP 24 16 1393

This annex lists the patent family members relating to the patent documents cited in the above-mentioned European search report. The members are as contained in the European Patent Office EDP file on The European Patent Office is in no way liable for these particulars which are merely given for the purpose of information.

04-08-2024

| Patent document cited in search report | Publication date | Patent family member(s) | Publication date |
|---|---|---|---|
| US 2022025109 A1 | 27-01-2022 | CN 113412533 A | 17-09-2021 |
| | | EP 3928348 A1 | 29-12-2021 |
| | | JP 2022521531 A | 08-04-2022 |
| | | KR 20210127712 A | 22-10-2021 |
| | | SG 11202106923X A | 29-07-2021 |
| | | TW 202041619 A | 16-11-2020 |
| | | US 2022025109 A1 | 27-01-2022 |
| | | WO 2020169702 A1 | 27-08-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004205685 A
- JP 6714493 B
- JP 2022529888 A
- JP 6189758 B
- JP 6786391 B
- JP 7050137 B
- JP 5746670 B
- JP 2007199653 A
- JP 2009269953 A
- JP 2002334869 A
- WO 2004066377 A1
- JP 2005128509 A
- JP 2004153125 A

### Non-patent literature cited in the description

- Improvement of the wiggling profile of spin-on carbon hard mask by H2 plasma treatment. *J. Vac. Sci. Technol.,* January 2008, vol. B26 (1), 67-71